(19) Europäisches Patentamt / European Patent Office / Office européen des brevets

(11) EP 3 612 822 B1

(12) # EUROPÄISCHE PATENTSCHRIFT

(45) Veröffentlichungstag und Bekanntmachung des Hinweises auf die Patenterteilung:
**02.10.2024 Patentblatt 2024/40**

(21) Anmeldenummer: **17722680.0**

(22) Anmeldetag: **18.04.2017**

(51) Internationale Patentklassifikation (IPC):
***G01N 24/10*** *(2006.01)* ***G01R 33/60*** *(2006.01)*
***G01R 33/30*** *(2006.01)* ***G01R 33/345*** *(2006.01)*

(52) Gemeinsame Patentklassifikation (CPC):
**G01N 24/10; G01R 33/307; G01R 33/345; G01R 33/60**

(86) Internationale Anmeldenummer:
**PCT/EP2017/000493**

(87) Internationale Veröffentlichungsnummer:
**WO 2018/192635 (25.10.2018 Gazette 2018/43)**

(54) **ESR-TESTS DER METABOLISCHEN ZELLAKTIVITÄT UND ESR-VORRICHTUNG DAFÜR**

ESR TESTS OF METABOLIC CELL ACTIVITY AND ESR DEVICE THEREFOR

TESTS RPE DE L'ACTIVITÉ CELLULAIRE MÉTABOLIQUE ET DISPOSITIF RPE ASSOCIÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**26.02.2020 Patentblatt 2020/09**

(73) Patentinhaber: **Noxygen Science Transfer&Diagnostics GmbH**
**79215 Elzach (DE)**

(72) Erfinder:
- **FINK, Bruno**
  **79215 Elztal (DE)**
- **FINK, Arthur**
  **79215 Elztal (DE)**

(74) Vertreter: **Mertzlufft-Paufler, Cornelius et al**
**Maucher Jenkins**
**Patent- und Rechtsanwälte**
**Urachstraße 23**
**79102 Freiburg im Breisgau (DE)**

(56) Entgegenhaltungen:
**WO-A1-2008/035068 WO-A2-2012/021453**
**US-A1- 2014 091 802**

- **M. BOHNE ET AL: "Effects of retinoids on the generation of neutrophil-derived reactive oxygen species studied by EPR spin trapping techniques", INFLAMMATION RESEARCH, vol. 46, no. 10, October 1997 (1997-10-01), CH, pages 423 - 424, XP055442439, ISSN: 1023-3830, DOI: 10.1007/s000110050216**
- **ANGE MOUITHYS-MICKALAD ET AL: "Oxygen consumption and electron spin resonance studies of free radical production by alveolar cells exposed to anoxia: inhibiting effects of the antibiotic ceftazidime", REDOX REPORT., vol. 7, no. 2, 2002, GB, pages 85 - 94, XP055442438, ISSN: 1351-0002, DOI: 10.1179/135100002125000316**
- **EUN-RYEONG HAHM ET AL: "Withaferin A-Induced Apoptosis in Human Breast Cancer Cells Is Mediated by Reactive Oxygen Species", PLOS ONE, vol. 6, no. 8, 10 August 2011 (2011-08-10), pages e23354, XP055442441, DOI: 10.1371/journal.pone.0023354**
- **MINORU YOSHIDA ET AL: "Melatonin prevents the increase in hydroxyl radical-spin trap adduct formation caused by the addition of cisplatin in vitro", LIFE SCIENCES., vol. 72, no. 15, 28 February 2003 (2003-02-28), GB, pages 1773 - 1780, XP055442440, ISSN: 0024-3205, DOI: 10.1016/S0024-3205(02)02480-3**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

- **SIBEL SUZEN ET AL: "Detection of Reactive Oxygen and Nitrogen Species by Electron Paramagnetic Resonance (EPR) Technique", MOLECULES, vol. 22, no. 1, 21 January 2017 (2017-01-21), pages 181, XP055442442, DOI: 10.3390/molecules22010181**

## Beschreibung

Die Erfindung betrifft eine Verwendung einer ESR-Vorrichtung zur differentiellen Charakterisierung von mindestens zwei unterschiedlichen Zuständen einer biologischen Probe, wie in Anspruch 1 oder einem davon abhängigen Anspruch definiert, sowie eine tragbare Vorrichtung zur Messung von Vitalparametern, welche ein mit einem Probenhalter für eine Kapillare zur Aufnahme einer biologischen Probe ausgestattetes ESR-Gerät beinhaltet, wie in Anspruch 2 mit Verweis auf Anspruch 4 bzw. Anspruch 3 mit Verweis nach Anspruch 5, oder einem davon abhängigen Anspruch, definiert.

Die moderne Medizin und Physiologie kennen eine Vielzahl von Parametern, die für Diagnostik und die Messung von Vitalität und Gesundheit von Patienten und gesunden Probanden geeignet sind.

Insbesondere die Risikobewertung bei Menschen hinsichtlich der Anfälligkeit für Erkrankungen und Zustände sind von Interesse, wie im Bereich des Herz- und Kreislaufsystems und bei entzündlichen Vorgängen, aber auch die Bewertung des Erfolges von Therapien mittels messbarer Parameter.

Unter den Messverfahren beginnt die Elektronenspinresonanzspektroskopie (ESR - auch als Electron Paramagnetic Resonance = EPR bezeichnet) neuerdings an Bedeutung zu gewinnen.

So beschreibt die WO 2012/021453 A2 eine Bewertung der anti-inflammatorischen Reaktion auf bestimmte (z.B. therapeutische) Stoffe auf lebende Zellen in vitro und in vivo unter Verwendung von ESR.

Ein Verfahren der Firma Noxygen Science Transfer & Diagnostics GmbH (Elzach, Deutschland) befasst sich (unter Korrelierung bis zu 25 Labor und Herzkreislauf-Funktions- und biologischen Parametern) mit einem automatisierten Vitalitäts- und NO-Bioverfügbarkeitstestsystem, das ebenfalls auf ESR basiert. Ein entsprechendes, für Forschungszwecke ausgelegtes System ist unter dem Namen NOXYSCAN-System auf dem Markt und ist als "Benchtop"-System (Labortischsystem) konzipiert. Das System erlaubt die Messung von reaktiven Sauerstoffspezies (ROS, z.B. $O_2^-$, OH·, $H_2O_2$), oxydativem Stress, Sauerstoffkonzentration, und Verbrauch, mitochondrialer Atmung und Dysfunktion, inflammatorischer Reaktion und Widerstand dagegen, und reaktiven Stickstoffspezies (RNS - wie ONOO-, NO, Hb, NO°-bioverfügbarkeit, Konzentration von zirkulierendem NOHb, endothelialer Dysfunktion) in vitro, in vivo und bei lebenden Tieren unter physiologischen und pathologischen Bedingungen. Auch die Messung von Substraten und Derivaten davon, wie SH-Gruppen, Vitamin C, Vitamin BH3*, dem intrazellulären pH und der Membranmikroviskosität ist auf diese Weise möglich.

Mittels einer Studie konnte nachgewiesen werden, dass eine hochsignifikante Korrelation zwischen ROS/NO und 25 Labor-, Stoffwechsel-, Entzündungs- und Herzfunktionsparametern bei der 3-monatigen Einnahme von einem multifunktionalem Nahrungsergänzungsmittel namens Peak-Performance-Pack besteht (noch unpubliziert). Die Anwendung dieser Erkenntnisse in der ärztlichen Praxis erlaubt hohe Einsparungen durch die Reduktion erforderlicher differenzialdiagnostischer Laboruntersuchungen.

Benchtop-EPR-Spektrometer sind bekannt und wurden für die Kontrolle der Geschmackserhaltung von Bier (Abbau durch ROS) eingesetzt (Wayne Openlander, Resonance Instruments News), doch wurde ausdrücklich hervorgehoben, dass einiges an Praxis und Training erforderlich war, um zu konsistenten Ergebnissen zu kommen. Die Messung geschah innerhalb einer flachen Messzelle.

Nemzer et al., Food Science & Nutrition, 2014, Seiten 1 bis 12, beschreibt die Verwendung von SPECTRA™, einem Nahrungsergänzungsmittel auf Basis einer Reihe von Früchten, Gemüsen und Kräuterextrakten und Konzentraten, zur ex-vivo-Modulation inflammatorischer Antworten nach TNF-$\alpha$-Stimulation. Die Messungen wurden mittels eines EPR-Spektrometers durchgeführt. Cyclische Hydroxylamine (Spinprobes) wie 1-Hydroxy-3-carboxy-pyrrolidin oder 1-Hydroxy-3-methoxycarbonyl-2,2,5,5-tetramethylpyrrolidin werden als Fänger ("Scavenger") für Superoxidradikale eingesetzt. Die Untersuchungen erfolgten mit dem erwähnten NOXYSCAN-Labortisch-System. Der verwendete Sauerstoffpartialdruck liegt bei 110 mmHg (14665.42 Pa).

Bohne et al., Inflammation Research, Bd. 46, Nr. 10, 1997, Seiten 423-424 und Ange Mouithys-Mickalad et al., Redox Report, Bd. 7, Nr. 2, 2002, Seiten 85-94, beschreiben ESR-basierte Methoden zur Bestimmung von ROS. Eun-Ryeyong Hahm et al., PLOS One, Bd. 6, Nr. 8, 2011 (Seite e23354) beschreibt eine ESR-Vorrichtung.

US 2014/091802 A1 beschreibt ESR-Spektrometer, bei denen Komponenten der Brücke als Leiterplatten gedruckt werden.

ESR beruht auf der Messung der Aufspaltung des magnetischen Moments ungepaarter Elektronen, das in einem magnetischen Feld in zwei entgegengesetzte Richtungen unterschiedlichen Energieniveaus ausgerichtet ist - bei Einstrahlung von Mikrowellen kann es zum "Umklappen" des magnetischen Moments vom niedrigeren Energieniveau zum höheren Energieniveau kommen und damit hinsichtlich der eingestrahlten Mikrowellen zu Absorption. Je nach Mikroumgebung der Elektronen (benachbarte Atome) kommt es bei gleichem Magnetfeld zu unterschiedlichen Absorptionsfrequenzen - oder umgekehrt bei konstanter Mikrowellenfrequenz und Variation des Magnetfeldes zu entsprechender Variation der Absorption der Mikrowellenstrahlung.

Zu den Schwächen von ESR zählen nach wie vor der hohe Preis der Ausrüstung und relativ hohe Raumanforderungen sowie das hohe Gewicht der Komponenten, insbesondere von Resonanzeinheit und Magnetsystem.

Der schwerwiegendste Nachteil jedoch besteht darin, dass die Messungen in der Regel nicht unter physiologischen Bedingungen durchgeführt werden können. Doch ist bekannt, dass abweichende Bedingungen zu abweichenden Messergebnissen führen können (beispielsweise wurde in einer Vielzahl von Publikationen die Signifikanz der Sauerstoffkonzentration für zahlreiche Experimente belegt), die nicht sinnvoll mit realen Bedingungen korreliert werden können. Insbesondere die hohe Temperaturabhängigkeit (bessere Signalintensität bei geringen Mengen an paramagnetischen Species, wenn sehr tiefe Temperaturen angewendet werden, z.B. früher Messung in flüssigem Stickstoff) führt zu weiteren Einschränkungen.

Aufgabe der vorliegenden Erfindung ist, ein Messsystem und Messverfahren bereitzustellen, das jeweils erlaubt, tatsächliche physiologische Bedingungen einzuhalten und zu kontrollieren und zugleich ein System bereitzustellen, das leicht transportabel ist und die Ermittlung sowie die Kontrolle einer Vielzahl von physiologischen Parametern bzw. Analyten insbesondere im klinischen und ambulanten ärztlichen Bereich ermöglicht.

Erfindungsgegenstände und Verkörperungen der Erfindung:

(A1) Die Aufgabe wird gelöst durch eine miniaturisierte tragbare, insbesondere handhaltbare Vorrichtung, welche ein mit einem Probenhalter für eine Kapillare zur Aufnahme einer biologischen Probe, wobei während einer Anwendung eine derartige Kapillare in den Probenhalter eingesetzt ist, ausgestattetes ESR-Gerät beinhaltet, dadurch gekennzeichnet, dass die Kapillare gasdurchlässig (gaspermeabel) ist, insbesondere für Sauerstoff, und temperaturregelbar ausgerüstet ist, Kontrollelemente für Temperatur und Sauerstoffpartialdruck und Elemente zur Einstellung der Temperatur und des Sauerstoffpartialdruckes in die Vorrichtung integriert sind, die es erlauben, im Messbereich die Temperatur in der biologischen Probe in einem Bereich von 36,6 +/-0,5 °C und den Sauerstoffpartialdruck in einem Bereich von 3999,66 bis 6666,1 Pa (35 bis 50 mmHg) einzustellen.

Insbesondere umfasst das ESR-Gerät eine Mikrowellenbrücke, welche einen Resonator, in den der Probenhalter während einer Anwendung eingesetzt werden kann bzw. eingesetzt ist, einen Oszillator und eine Mikrowellenreflektionsstrecke, die vorzugsweise als Koaxialkabel ausgebildet ist, als eine Einheit durch, jeweils schichtweises und/oder punktweises, Aufschmelzen und/oder Sintern und/oder chemisches Umsetzen und im Falle der Verwendung von Kunststoff/Metallteilchen-Dispersionen unter Trocknen, insbesondere 3D-Druck, ausgebildet bzw. hergestellt ist.

Eine ganz besonders wichtige Erfindungsverkörperung (B1) beinhaltet die Verwendung einer erfindungsgemäßen oder einer sonstigen ESR-Vorrichtung zur differentiellen Charakterisierung von mindestens zwei unterschiedlichen Zuständen einer biologischen Probe, wobei

- in einem ersten Schritt mittels ESR und eines Spinprobes in Form eines ungeladenen oder eines negative Gruppen tragenden zyklischen Hydroxylamins reaktive Sauerstoffspezies (ROS), reaktive Stickstoffspezies (RNS) oder beides und/oder mittels Verbindungen, die durch Anlagerung von Sauerstoff je nach Sauerstoffpartialdruck Verbeiterung des Peaks bei zunehmender Sauerstoffkonzentration zeigen ohne chemische Reaktion, also durch rein physikalische Wechselwirkungen, die durch die Nähe unterschiedlicher Mengen an Sauerstoff entstehen, die Sauerstoffkonzentration der biologischen Probe ohne Zusatz von Effektoren gemessen werden und
- in einem zweiten Schritt mittels ESR mittels eines Spinprobes in Form eines n oder eines negative Gruppen tragenden zyklischen Hydroxylamins die ROS, die RNS oder die ROS und die RNS einer gleichen biologischen Probe jeweils unter Zusatz von Effektoren gemessen werden,

  wobei die Reihenfolge von erstem und zweitem Schritt auch beliebig sein kann;

  und/oder
- aufgrund von mindestens zwei ESR-Messungen der biologischen Probe mit unterschiedlichen Spinprobes, die in unterschiedlicher Weise extrazelluläre Flüssigkeit, intrazelluläre Flüssigkeit und das Innere von Mitochondrien erreichen können, mit oder ohne Bestimmung der Sauerstoffkonzentration mittels Verbindungen, die durch Anlagerung von Sauerstoff je nach Sauerstoffpartialdruck Verbeiterung eines Peaks der ESR-Absorption bei zunehmender Sauerstoffkonzentration zeigen ohne chemische Reaktion, also durch rein physikalische Wechselwirkungen, die durch die Nähe unterschiedlicher Mengen an Sauerstoff entstehen, unterschiedliche Messergebnisse erhalten werden;

und jeweils durch Vergleich der unterschiedlichen Messergebnisse unter Differenzbildung aus der Differenz Schlüsse auf die Vitalität oder die Gesundheit von Patienten oder gesunden Probanden, von dem die biologische Probe stammt, gezogen werden;

wobei die Messung bei einer Temperatur in der biologischen Probe in einem Bereich von 36 bis 44 °C und der Sauerstoffpartialdruck in einem Bereich von 2666.4 bis 7332,71 Pa (20 bis 55 mmHg) eingestellt ist;
und

wobei unter "Effektoren", wo erwähnt, Inhibitoren oder Aktivatoren oder sonstige Modulatoren, von Enzymen, Enzymsystemen oder Organellen zu verstehen sind, die auf die Bildung von ROS und/oder RNS Einfluss haben.

Mit anderen Worten, es handelt sich hierbei um eine Differentialverwendung unter zwei (oder mehr) Bedingungen, bei denen aus Differenzen zwischen Messwerten Schlüsse auf die Vitalität bzw. Zustände eines Probanden, von dem die biologischen Proben stammen, gezogen werden können.

Nur für Referenzzwecke und nicht als Erfindungsgegenstand offenbart der vorliegende Text Verfahren oder Methoden, bei denen eine erfindungsgemäße vor- und/oder nachstehend genannte miniaturisierte tragbare, insbesondere handhaltbare Vorrichtung eingesetzt wird, in der in Gegenwart mindestens eines zyklischen Hydroxylamins als Spinprobe reaktive Sauerstoffspezies, Sauerstoff und/oder reaktive Stickstoffspezies mittels ESR-Absorptionsmessungen ermittelt und die Messsignale gespeichert und/oder visualisiert und vorzugsweise die reaktiven Sauerstoffspezies, Sauerstoff und/oder die reaktiven Stickstoffspezies qualitativ oder quantitativ bestimmt werden.

Bei der Verkörperung B1, insbesondere (auch generell) bei Messung ansonsten gleicher biologischer Proben, können insbesondere auch solche erfindungsgemäßen Vorrichtungen Einsatz finden, deren Probenhalter die gleichzeitige Messung von zwei oder mehr biologischen Proben ermöglicht (z.B. durch entsprechende Anzahl von Probenräumen oder Aufnahme von zwei oder mehr Kapillaren in einem einzigen Probenraum), insbesondere solchen, die unterschiedlichen Zuständen der jeweiligen Proben entsprechen. Vorrichtungen mit Probenhaltern für gleichzeitige Messung von zwei oder mehr Kapillaren für biologische Proben in unterschiedlichen Zuständen sind daher eine besondere Ausführungsform der Erfindung. Mehrere Probenhalter im selben Resonator ermöglichen auch die Messung mehrerer Proben gleichen Inhalts, wobei durch die Verwendung der Kapillaren bessere Äquilibrierung hinsichtlich Temperatur und Sauerstoff in den Proben ermöglicht wird, und dennoch größere Volumina an Proben gemessen werden können.

Unterschiedliche Zustände sind dabei wie in Anspruch 1 genannt solche, die einen Vergleich einer biologischen Probe mit oder ohne Effektoren und/oder mit Spinprobes, die in unterschiedlicher Weise extrazelluläre Flüssigkeit, intrazelluläre Flüssigkeit und das Innere von Mitochondrien erreichen können, ermöglichen.

Biologische Proben sind insbesondere Blut, oder ferner Blutplasma oder Blutserum, oder noch ferner Lymphflüssigkeit, Speichel, Urin, Schleim aus den Atemwegen, Verdauungssäfte, Milch, Galle, Sperma, Ohrenschmalz, Körper- oder Blutzellen, Gewebe oder Organteile sowie daraus abgeleitete Flüssigkeiten wie Blut, Blutersatz oder Lymphe, jeweils von Tieren, insbesondere Säugetieren, vor allem Menschen.

Physiologische Bedingungen sind insbesondere solche wie sie im Blutkreislauf bei Tieren, insbesondere Menschen, oder in deren Flüssigkeit zwischen Zellen von Geweben und dergleichen herrschen.

Während frühere Messungen wie erwähnt einen Sauerstoffpartialdruck im Bereich von 14665.42 Pa (110 mmHg) anwendeten, wird in den erfindungsgemäßen Verwendungen, ein Sauerstoffpartialdruck im Bereich von 2666,44 - 7332,71 Pa (20 bis 55 mmHg), vorzugsweise von 4666,26 - 6666,10 (35 bis 50 mmHg), insbesondere von etwa 5332,88 Pa (40 mmHg), angewendet. Dies entspricht dem Wert, der in Blutkapillaren im Körper von Tieren, insbesondere dem Menschen, aufgefunden wird. Daher ist dies ein besonders wichtiger Aspekt der vorliegenden Erfindung.

Besonders bevorzugt sind ein Sauerstoffpartialdruck im Bereich zwischen von 5332,88 bis 6666,1 Pa (40-50 mmHg) (1 mmHg entspricht 133,322 Pa oder 1,33322 bar) und eine Temperatur in der Messzelle von 36 bis 44 ° C (was auch Fieber bei Menschen impliziert), insbesondere von 36,4 bis 36,8 °, z.B. von 36.5 bis 36.7 °C, vorzugsweise von 36,6 +/- 0,1 °C.

Daneben können auch der pH, der Kohlendioxidgehalt oder die Strömungsgeschwindigkeit sowie andere Parameter wie eingangs genannt an die in den Tieren, von denen die biologischen Proben stammen, physiologischen Bedingungen angepasst werden.

Nachfolgend werden Merkmale genannt, die, einzeln oder zu mehren oder alle anstelle von oder zusätzlich zu vor- und nachstehend genannten Merkmalen bzw. Bezeichnungen eingesetzt werden können und so bevorzugte Ausführungsformen der erfindungsgemäßen Vorrichtung, Verfahren und Verwendungen beschreiben können und beispielsweise in den nachfolgenden Ansprüchen eingesetzt werden können.

Wo von Vitalität die Rede ist, ist stets insbesondere die Metabolische Zellaktivität (englisch metabolic cell activity) darunter zu verstehen, so dass "Vitalität" in bevorzugten Erfindungsausführungsformen durch diesen Begriff in geeigneter Weise ersetzt werden kann.

Effektoren in Verwendungen der Erfindungsverkörperung (B1) sind beispielsweise Inhibitoren oder Aktivatoren, oder ferner sonstige Modulatoren, von Enzymen, Enzymsystemen oder Organellen wie Mitochondrien, die auf die Bildung von ROS und/oder RNS Einfluss haben. Beispiele hierfür sind die Wirkstoffe der Arzneimittel in der Roten Liste 2016 für Arzneimittel; Editio Cantor Verlag, Aulendorf 2016 (hier durch Bezugnahme aufgenommen), wie insbesondere - Antibiotika, insbesondere Macrolidantibiotika, wie Clarithromycin, Erythromycin, Azithromycin, Roxithromycin, Spiramycin oder Josamycin, ferner Ketolide, wie Telithromycin, ferner

- schwer wasserlösliche antivirale Therapeutika, z.B. antiretrovirale Proteasehemmer, wie Indinavir, Saquinavir, Ritonavir oder Nelfinavir;
- Analgetika, wie Paracetamol;
- Herz-Kreislaufmittel, z.B. Ca-Antagonisten, wie Nifedipin, oder ACE-Hemmer, wie Captopril oder Enalapril,;
- Antiphlogistika, wie Glucocorticoide, z.B. Cortison, Prednisolon oder Prednisolonacetat,

- Krebstherapeutika, wie Mitosehemmstoffe, beispielsweise Hemmstoffe der Mikrotubuli-Desaggregation, wie Taxane, z.B. Paclitaxel oder Docetaxel,
- NSAR wie Acetylsalicylsäure oder weitere nichtsteroidale Antirheumatika (NSAR oder englisch NSAIDs), wie sonstige Acetylsalicylsäurederivate, Acetylpropionsäurederivate, wie Flurbiprofen, Naproxen (vor allem das S-Enantiomer), Ketoprofen oder insbesondere Ibuprofen oder Tiaprofensäure, Arylessigsäurederivate wie Diclofenac, Indolessigsäurederivate wie Indometacin, Anthranilsäurederivate wie Flufenamin oder Mefaminsäure, oder Oxicame wie Piroxicam, Tenoxicam oder Meloxicam, zu verstehen
- COX-Inhibitoren, wie eher COX-2-spezifische Inhibitoren ("Coxibe") wie Refexocib, Lumiracoxib, Valdecoxib oder insbesondere Celocoxib, Etoricoxib oder Parecoxib oder sonstige Mittel, beispielsweise ausgewählt aus den folgenden:

  Antipyretica, Analgetica, Antiphlogistica, Antiarrhythmica, Antihypertensiva, Vasodilatoren, Anticholinergica, Antiarteriosclerotica, Enzyme, Antikörper, Secretolytica, Mittel gegen Magengeschwüre, Antiproliferative Wirkstoffe, Vasoconstrictoren, Expectorantien, Antitussiva, Mucolytica, Secretomotorisch wirksame Stoffe, Sympathicometica (wie Phenylephrin, Ephedrin, Tetryzolin, Naphazolin, Oxymetozolin, Xylometazolin oder Tramazolin), Antihistamine, non-steroidale oder steroidale Anti-inflammatorsch Aktive Substanzen (wie Triamcinolone acetonide, Glucocorticoide, wie Prednisolon, Triamcinolonacetonide Clomethason, Dexamethason, oder Fluticason), Sympathomimetica; Mastzell-Stabilisatoren, Aromatasehemmer; Antiöstrogene; Topoisomerase I Hemmer, Topoisomerase II Hemmer; Microtubuliaktive Verbindungen; Alkylantien; Histon Deacetylase Hemmer; Verbindungen, die Zelldifferenzierungsprozesse initiieren; Cyclooxygenase-Hemmer; MMP-Hemmer; mTOR_Hemmer; Antineoplastische Antimetaboliten; Platinverbindungen; Verbindungen, welche auf eine Protein- oder Lipidkinaseaktivität oder eine Protein- oder Lipidphosphataseaktivität zielen oder sie vermindern; Gonadorelinagonisten; Anti-Androgene; Methioninaminopeptidasehemmer; Bisphosphonate; Biological response modifiers; Antiproliferative Antikörper; Heparanasehemmer; Inhibitoren Ras oncogener Isoformen; Telomeraseinhibitoren; Proteasomeinhibitoren; Verbindungen, die bei der Behandlung haematologischer bösartiger Erkrankungen wirken; Verbindungen, welche auf die Aktivität von Flt-3 zielen, sie hemmen oder aktivieren; Hsp90-Inhibitoren wie 17-AAG (17-allylaminogeldanamycin), 17-DMAG (17-dimethylaminoethylamino-17-demethoxygeldanamycin, IPI-504, CNF1010, CNF2024, CNF1010 von Conforma Therapeutics; Temozolomid; Kinesinspindelproteininhibitoren, wie SB715992 oder SB743921 von GlaxoSmithKline, oder Pentamidin/Chlorpromazin von CombinatoRx; MEK-inhibitoren wie ARRY142886 von Array PioPharma, AZD6244 von AstraZeneca, PD181461 von Pfizer, Leucovorin, EDG binder, Antileukaemieverbindungen, Ribonucleotidreductaseinhibittoren, S-adenosylmethionindecarboxylaseinhibitoren, Antiproliferative Antikörper oder andere chemotherapeutische Verbindungen; Tricyclica, z.B. Benzodiazepine einschließlich mitochondrialer Benzodiazepinliganden, MAO-Inhibitoren, SSRI's, SNRI's, NK Receptorantagonisten, CRF-Receptorantagonisten, 5HT7 Receptorantagonisten, mGlu Receptoragonisten/antagonisten/modulatoren, GABA-A oder GABA-A/B Receptoragonisen/antagonisten oder -modulatoren, Vasopressinreceptorantagonisten, Pflanzliche Arzneimittel wie Johanniskraut, 5-HT1A Receptoragonisten, Vasopressinreceptorantagonisten, Acetylcholinesteraseinhibitoren, wie Rivastigmin oder Donepezil, gemischte Acetylcholin/butyrylcholinesteraseinhibitoren. Nicotini-alpha7-Receptor Agonisten, Antipsychotica, wie Clozapin oder Haloperidol, antimanische Wirkstoffe (z.B. Lithium, Carbamazepine, Valproat), oder andere atypische oder typische Antipsychotica; Nahrungsergänzungsmittel; oder dergleichen mehr.

Hier können insbesondere Biologische (insbesondere Blut-) Proben aus Probanden (Tiere, insbesondere Menschen) mit und ohne entsprechende Effektoren (gleiche Probanden zu unterschiedlichen Zeitpunkten oder unterschiedliche Probanden) untersucht und aus den Differenzen mit und ohne Effektorzugabe (zum Patienten oder der jeweiligen biologischen Probe) verglichen werden.

Eine besondere Variante betrifft Effektoren, welche die Mitochondrienaktivität inhibieren, wobei aus der Differenz zwischen ROS und/oder RNS-Signalintensität mit und ohne Effektor auf den Beitrag der Mitochondrien zur ROS und/oder RNS-Bildung. Beispiele für solche Effektoren sind Inhibitoren der Komplexe I, II, III, IV und/oder ATP-Synthase, wie beispielsweise für Komplex I $MPP^+$, Aminobarbital Rotenon oder Biguanide (wie Metformin), für Komplex II 3-Nitropropionsäure, Malonat oder ein fungizider Succinatdehydrogenaseinhibitor, für Komplex III Antimycin A oder Strobillurine, für Komplex IV ein Cyanidsalz oder ein Azidsalz bzw. die jeweils entsprechende Säure, für ATP-Synthase Oligomycin, oder auch ein Entkoppler der Atmungskette, wie Thermogenin, 2,4-Dinitrophenol, Carbonylcyanid-m-chlorphenylhydrazon, Carbonylcyanid-p-trifluoromethoxyphenylhydrazon oder Pentachlorphenol; auch Mischungen von zwei oder mehr dieser Effektoren sind möglich.

ROS und/oder RNS-Signalintensität bezieht sich dabei auf die (in der Regel mittels Spinprobe) ermittelte ESR-Signalintensität, wie sie durch Übertragung der Radikaleigenschaft von ROS und/oder RNS auf ein oder mehrere Spinprobes hervorgerufen wird.

Eine weitere besondere Variante betrifft beispielsweise Inhibitoren der Endothelialen NO-Synthase: Während bei gesunden Probanden mit intakter Endothelialer NO-Synthase nur geringe Radikalmengen (NO-Radikal und O-Radikale, also ROS und RNS) gemessen werden, kommt es bei Messung des Blutes von Probanden mit dysfunktionaler

Endothelialer NO-Synthase zur vermehrten Bildung von ROS und/oder RNS. Dadurch werden die (mittels Spinprobes ermittelten) ESR-Signaintensitäten erhöht. Gibt man Hemmstoffe der Endotheliaen NO-Synthase hinzu, werden diese Signale (wegen verminderter Produktion der Radikale) weniger intensiv. Man kann also unterscheiden, ob die Radikalbildung auf der Bildung durch die Endotheliale NO-Synthase beruht oder nicht, indem die Differenz der Signalintensität in An- und Abwesenheit des NO-Synthaseinhibitors gemessen wird. So können gesunde (geringe Differenz) und hinsichtlich der Funktionalität der Endothelialen NO-Synthase beeinträchtigte Proben (größere Differenz) unterschieden werden.

Beispiele für NO-Synthasehemmer, ohne dass dies limitierend sein soll, sind N-Methylarginin, L-Nitroarginin, L-NAME (Nw-Nitro-L-Argininmethylester), L-NIO (L-$N^5$-(1-Imunoethyl)ornithin), 1400W (N-(3-Aminomethyl)benzylacetamidine), oder N-AANG ((4S)-N-(4-Amino-5[aminoethyl]aminopentyl)-N'-nitroguanidine).

Sämtliche Effektoren können als freie Verbindung und/oder als Salz vorliegen.

Auch durch Messung mit Spinprobes, die in unterschiedlicher Weise dem extrazellulären Raum, dem intrazellulären Raum oder dem Mitochondrieninneren zugänglich sind, können bei Messungen unter Verwendung unterschiedlicher Spinprobes (Erfindungsverkörperung (B1)) die entsprechenden Räume separat differentiell auf das Auftreten von ROS und/oder RNS untersucht werden. So kann ermittelt werden, ob ROS und/oder RNS auf der Ebene des extrazellulären, des intrazellulären oder des intramitochondrialen Raums entstehen und damit auf die Funktionalität entsprechender Räume geschlossen werden.

Entsprechende unterschiedliche Spinprobes, die in unterschiedlicher Weise extrazellulärer Flüssigkeit, intrazellulärer Flüssigkeit und dem Inneren von Mitochondrien erreichen können, sind beispielsweise solche, die (insbesondere negativ) geladene Gruppen wie Phosphonogruppen oder Sulfongruppen mit freien an P bzw. S gebundenen OH-Gruppen tragen, die für die Messung des Extrazellulärraums geeignet sind (sie penetrieren nicht die Zellmembran); und solche, die die genannten Räume alle penetrieren (z.B. nicht negativ geladene Spinprobes), so dass aus der Messung der Differenz der ESR-Absorptionsintensitäten zwischen nur den Extrazellulärraum erreichenden und den alle Räume erreichenden Spinprobes auf den Beitrag des Intrazellulärraums und des Extrazellulärraums geschlossen werden kann.

Spinprobes sind allgemein Verbindungen, die durch Übertragung der Radikaleigenschaft von Atom- oder Molekülspezies mit sehr kurzer Halbwertszeit (wie ROS, RNS) sehr langlebige Radikale (Halbwertszeiten mehrere Stunden) bilden und so lange mittels ESR messbar sind.

Beispiele für ungeladene zyklische Hydroxylamine sind 1-Hydroxy-3-methoxy-2,2,5,5-tetramethylpyrrolidin (CMH) oder 1-Hydroxy-2,2,6,6-tetramethylpiperidin-4-yl-trimethylammoniumchlorid (CAT-1H).

Beispiele für negative geladene Gruppen tragende zyklische Hydroxylamine sind PPH = 1-Hydroxy-4-phosphono-oxy-2,2,6,6-tetramethyl-piperidin, die bei intakten (vitalen) Zellen nicht ins Zellinnere (durch aktiven Transport oder Diffusion) aufgenommen werden.

Der Begriff "zyklische Hydroxylamine" schließt dabei auch zyklische Nitroxide wie TEMPO oder 4-Amino-TEMPO oder 4-[(5-aminopentyl)carbonylamino]-TEMPO)) als Spinprobe mit ein. Vorzugsweise sind jedoch tatsächlich Hydroxylamine gemeint.

Die Messungen (und somit auch gewünschtenfalls die Kontrolle und Regelung) des Sauerstoffgehaltes bei jeder oder jedem der genannten erfindungsgemäßen Verwendungen, Verfahren oder Methoden kann beispielsweise mittels Verbindungen wie geschehen, die durch Anlagerung von Sauerstoff je nach Sauerstoffpartialdruck unterschiedliche Breite der Peaks der ESR-Absorption (Verbeiterung des Peaks bei zunehmender Sauerstoffkonzentration) zeigen ohne chemische (z.B. Radikalübertragungs-) Reaktion, also durch rein physikalische Wechselwirkungen, die durch die Nähe unterschiedlicher Mengen an Sauerstoff entstehen. Solche Verbindungen sind beispielsweise Tritylradikalverbindungen wie von A. Bobko et al. In Free Radical Biological Medicine 47, 654-658, 2009, oder Y. Liu et al., Free Radic Biol Med. 2009 Apr 1;46(7):876-83., beschrieben,

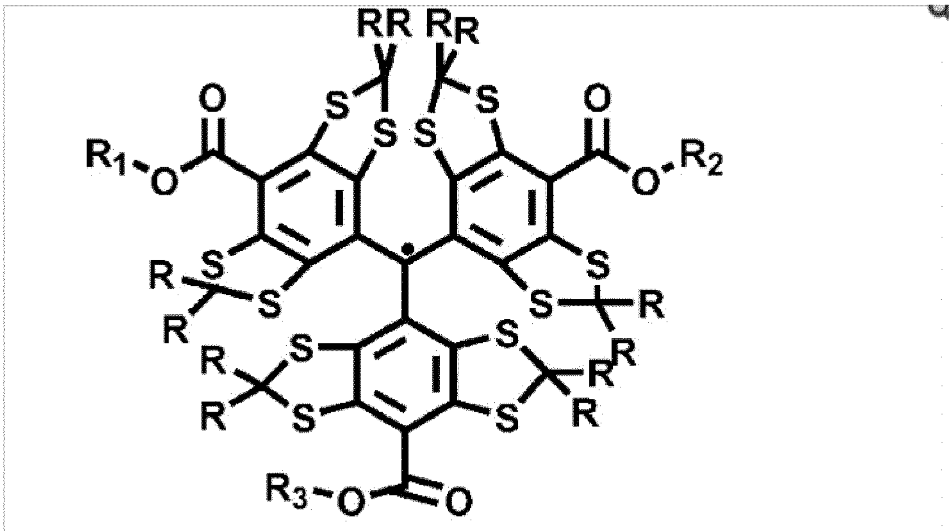

CT-03 $R = CH_3, R_1 = R_2 = R_3 = Na$
Ox063 $R = (CH_2)_2OH, R_1 = R_2 = R_3 = Na$
MT-03 $R = CH_3, R_1 = R_2 = R_3 = CH_3$
BT-03 $R = CH_3, R_1 = R_2 = R_3 =$ *tert*-Butyl
AMT-03 $R = CH_3, R_1 = R_2 = R_3 = CH_2OC(O)CH_3$
AMT-02 $R = CH_3, R_1 = R_2 = CH_2OC(O)CH_3, R_3 = H$

(Liu et al., a.a.O.) oder vor allem eine ausgewählt aus solchen der Formeln

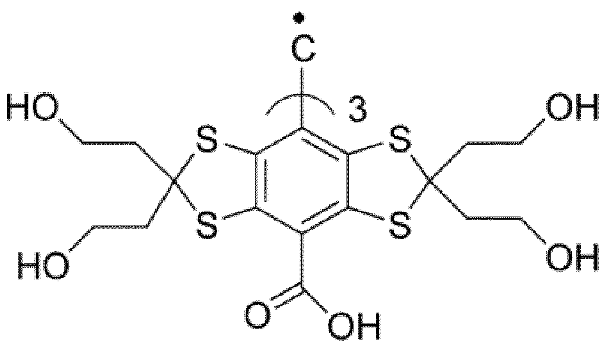

Oxo63

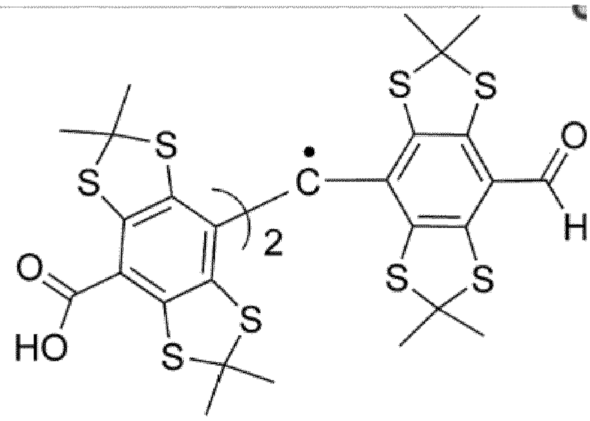

TAM-H

(Bobko et al., a.a.o.), insbesondere das als NOX-15.1 vertriebene Tris(8-Carboxyl-2,2,6,6-tetramethylbenzo-[1,2-d;4,5-*d'*]bis[1,3]dithiol-4-yl)methyl-Natriumsalz.

Wo im Rahmen der vorliegenden Offenbarung von "etwa" die Rede ist, bedeutet dies jeweils, dass der betreffende Zahlenwert um +/- 2 %, vorzugsweise +/- 1 %, sehr bevorzugt 0,1 % vom genannten Zahlenwert abweichen kann, oder insbesondere gar nicht von diesem Zahlenwert abweicht.

Wo von "ferner" die Rede ist, bedeutet dies, dass andere der Merkmale ohne diesen Zusatz bevorzugter als die mit "ferner" gekennzeichneten.

Eine erfindungsgemäße Vorrichtung gemäß Anspruch 4 oder Anspruch 5 ist vorzugsweise wie folgt durch ein

oder mehrere oder alle der nachfolgend genannten Merkmale charakterisiert:

- Messbereich von 100 bis 500 nMol/sek, insbesondere von 150 bis 360 nMol/sek, vorzugsweise von 240 bis 300 nMol/sek;
- Genauigkeit (Signal/Rauschverhältnis) vorzugsweise von 5 % oder besser, insbesondere von 3 % oder besser (d.h., 5 % Rauschen bei 95 % Signal oder weniger, 3 % Rauschen bei 97 % Signal oder weniger);
- Auflösung gleich oder mehr als $3 \times 10^{-4}$ T;
- Feldstabilität über 1 Stunde > $3 \times 10^{-5}$ T;
- Empfindlichkeit von < 5 nM/min (d.h. eine Änderung von 5 nmol pro Minute oder weniger der Radikalkonzentration in der biologischen Probe ist messbar);
- Automatische Datensicherung (z.B. auf Festplatte oder anderem Festspeicher), um die Daten zu sichern;USB-Schnittstelle oder andere übliche Schnittstelle (z.B. RS 232);
- Datenerfassungssoftware, die das Gerät steuert, die Messergebnisse erfasst und sie gewünschtenfalls auch auswerten kann;
- Galvanische Trennung zwischen Datenschnittstelle und Stromversorgung (z.B. über einen Elektrolytkondensator oder ein Akku/Batterieelement, wobei vorzugsweise das Netzteil separat vom Gehäuse der Vorrichtung ist);

Vorzugsweise handelt es sich um ein tragbares Tischgerät, Gewicht im Bereich von 5 bis 20 kg, z.B. 7 bis 10 kg, beispielsweise 8,5 kg.

Die Größe liegt vorzugsweise bei (200-500mm) x (100 bis 350mm) x (100 bis 350mm), beispielsweise 350 x 280 x 265 mm.

Die Leistungsaufnahme liegt insbesondere bei < 100, vorzugsweise < 50 Watt, beispielsweise von 20 bis 50 Watt.

Die Mikrowellenbaugruppe ("Mikrowellenbrücke" einer erfindungsgemäßen Vorrichtung (die selbst eine beanspruchbare Ausführungsform der Erfindung ist) weist vorzugsweise ein oder mehrere oder alle der nachfolgend genannten Merkmale auf:

- Integrierte Mikrowellen- und Resonatorbaugruppe als vorgeformte Einheit, vorzugsweise mittels 3D-Druck oder analogen Verfahren wie nachfolgend noch beschrieben erhältlich oder erhalten;
- Frequenzbereich vorzugsweise im Bereich von 8 bis 12, insbesondere von 9 bis 10, z.B. von 9,2 bis 9,5 GHz;
- Mikrowellenresonator in 3D-Druck (Resonanzabstimmung);
- Öffnung des Probenhalters für Probeninhalte ca. 3 bis 7 mm, vorzugsweise 5 mm Durchmesser; dies gewährleistet genug Raum für die Zufuhr von Gas zur Temperierung und zur Einstellung des gewünschten Sauerstoffpartialdruckes;
- Lage des Probenhalters zentral im Resonator dort wo die stärkste Magnetfeldintensität der im Resonator ausgebildeten stehenden Welle herrscht;
- Rechteckresonator;
- Güte des leeren Resonators $Q \geq 4000$ (Maß für die Empfindlichkeit);
- Dynamische Bandbreite des Verstärkers vorzugsweise 8 bis 15, insbesondere von 10 bis 12 MHz;
- Leistung des Mikrowellengenerators vorzugsweise 5 bis 20 mW, insbesondere 10 mW;
- Verstärkung vorzugsweise digital bis zu 3000fach;
- Frequenzstabilisierung $10^{-5}$ bis $10^{-6}$ $10^{-6}$ (automatische Frequenzstabilisierung).

Die Magnetfeldbaugruppe weist vorzugsweise ein oder mehrere oder alle der nachfolgend genannten Merkmale auf:

- Permanentmagnet mit 40 bis 70, vorzugsweise z.B. 60 mm Magnetpoldurchmesser;
- Spulen zur Änderung der magnetischen Flussdichte vorzugsweise im Bereich von +/-0,1 G (+/- 0,01 mT) bis +/- 0,5 G (+/- 0,05 mT), z.B. von +/- 0,2 G (+/- 0,02 mT);
- Durchmesser des Magnetfeldes (Messzone) ca. 10 bis 30, insbesondere 15 mm;
- Abstand zwischen den Magnetpolen von 10 bis 30, insbesondere von 12 bis 15 mm;
- Abmessungsgenauigkeit reproduzierbar 10 $\mu$m, Rundheit 3 $\mu$m;
- Magnetgewicht vorzugsweise 1 bis 5 kg, insbesondere 1,5 bis 2,5 kg, z.B. 2 kg.

Der Resonator ist vorzugsweise (gemessen in der Richtung zwischen den Magnetpolen) 8 bis 10 mm groß, die (rund oder eckig ausgeführte, vorzugsweise rund) Öffnung für den Probenhalter darin hat vorzugsweise einen Durchmesser (gemeint ist immer der äußere Durchmesser) von 3 bis 5 mm, der Probenhalter einen äußeren Durchmesser von 2 bis 4 mm, die Kapillare hat vorzugsweise einen Durchmesser (gemeint ist jeweils der äußere Durchmesser, soweit

nicht anders ersichtlich) von 0,5 bis 2 mm, z.B. von 1,2 bis 1,5 mm (so dass ein kleiner Spalt zwischen Kapillaraußenwand und Probenhalterinnenwand gegeben ist, der das Durchströmen des Gases zur Einstellung des Sauerstoffpartialdruckes ermöglicht).

Die Kapillare kann beim Messvorgang ("in Anwendung") statisch mit der der biologischen Probenflüssigkeit gefüllt sein oder (beispielsweise mittels einer peristaltischen Pumpe) von dieser durchströmt werden. So können auch Effekte von Blutdruck (Hypertonie, Hypotonie) oder Strömung (Einwirkung von Scheerkräften) gemessen werden.

Für die Probenvorbereitung (insbesondere im Rahmen der erfindungsgemäßen Verwendung bzw. des erfindungsgemäßen Verfahrens) gilt insbesondere:

- Probenmenge vorzugsweise 5 bis 30 $\mu$l, insbesondere 8 bis 15 $\mu$l, z.B. 10 $\mu$l (Menge im Messbereich des Probenhalters/Resonators);
- Sauerstoffversorgung $pO_2$ vorzugsweise 5332,88 +/- 266,64 Pa (40 mmHg +/- 2 mmHg); diese erfolgt mittels eines sauerstoffhaltigen Gasgemisches (vorzugsweise 4 % Sauerstoff)
- Temperierung vorzugsweise 36,6 °C +/- 0,1 °C
- Einwegkapillare (vorzugsweise mit Spinprobe-Beschichtung. Die Beschichtung kann beispielsweise über Makromoleküle wie Proteine oder Polysaccharide erfolgen, an die die Spinprobes (beispielsweise über Carbonylgruppen durch Reaktion mit Aminogruppen oder Hydroxygruppen der Makromoleküle) gebunden sind und mittels derer die Innenwand der Kapillare beschichtet ist) gebunden sein;
- Kapillardurchmesser außen 0,5 bis 2 mm, insbesondere 1,0 bis 1,2 mm;
- Analysendauer 5 bis 6 Minuten.

Mögliche bevorzugte Einsatzgebiete für die erfindungsgemäße Vorrichtung bzw. die erfindungsgemäßen Verwendungen finden sich in der - jeweils diagnostischen und/oder therapeutischen - Kardiologie und Angiologie, Anästhesiologie, Hämatologie, Sportmedizin, Rehabilitationsmedizin, Umweltmedizin, Traumatologie und/oder Chirurgie, oder bei der diagnostischen und/oder therapeutischen Überwachung von toxikologischen und/oder pharmakologischen Wirkungen, Alterungserscheinungen, der Zellvitalität oder der metabolischen Aktivität der Zelle.

Auch die Messung der Gegenwart und Menge freier Radikale, ihrer Bildung und ihres Abbaus, Auswirkungen der Ernährung auf oxidativen und nitrosativen Stress in Mensch und Tier sind bevorzugte Einsatzgebiete.

Es können biologische Proben (bevorzugt Blut) von gesunden oder kranken Probanden, mit Effektoren behandelten oder unbehandelten Probanden, insbesondere jeweils Menschen, untersucht werden, so dass insbesondere im ersteren Fall auch Aussagen über potentielle Risiken und mögliche zukünftige Erkrankungen erkannt und dann vorzugsweise prophylaktisch behandelt werden können.

Eine Reihe von Materialien können für die Kapillare verwendet werden. Allgemein sind insbesondere Materialien auf siliziumorganischer Basis, wie Silikon oder Polysilikon, zu nennen. Weitere bevorzugte Materialien sind u.a. Kunststoffe (Polymere) wie Polymethylmethacrylat (PMMA), Polycarbonat, Polyester, Polyamide, Polytetrafluorethylen (TEFLON®), Polyvinylchlorid (PVC), Polydimethylsiloxan (PDMS), Polysulfon, Polystyrol, Polyolefine, wie Polymethylpenten, Polypropylen oder Polyethylen, Polyvinylidinfluorid, Acrylnitril-Butadien-Copolymer (ABS), Blockcopolymere oder Gemische von zwei oder mehr davon. Die Kapillaren können unter Verwendung bekannter Formungsverfahren, wie Spritzguss, Extrusion, Ziehen, Polymerisation des monomeren Vorläufermaterials innerhalb der Form (Urform). Derartige polymere Materialien sind bevorzugt, da sie leicht herstellbar, preisgünstig und auch wegwerfbar sein können. Jedoch sind Kapillaren auf Polymer- oder Glasbasis besonders bevorzugt. Alle genannten Materialien können spezifisch behandelte oder beschichtete Oberflächen oder Oberflächenabschnitte (z.B. innerhalb der Mikrokanäle) enthalten, beispielsweise durch Silanierung (Beschichtung mit einem Silan, an das ein eine Hydroxygruppe tragendes Verbindungsmolekül gekoppelt wird), Anätzung von Glas, so dass die Oberfläche viele Hydroxygruppen aufweist, beispielsweise mit Caro'scher Säure, oder anderweitige Einführung reaktiver Gruppen (z.B. Epoxidgruppen, aktivierte Estergruppen, Dien- oder Dienophilgruppen oder dergleichen).

Kapillaren können durch Recken von Rohren aus einem (mindestens in der Hitze) dehnbaren Material (wie einem thermoplastischen Kunststoff) gewonnen werden. Beispiele für geeignete Kapillaren sind PTFE-Kapillaren, die von Zeuss Corp., Raritan, USA kommerziell erhältlich sind.

Die Herstellung der in Anspruch 5 definierten Mikrowellenbrücke erfolgt vorzugsweise durch schicht- und/oder punktweises Aufschmelzen oder Sintern (eine Variante additiver Fertigung) (was die oben als analog zu 3D-Druck und 3D-Druckverfahren selbst genannten Verfahren umfasst).

Dies bezieht sich auf ein Verfahren, bei dem erst ein pulverförmiges oder anderweitig feinkörniges Material oder eine Mischung von solchen Materialien oder eine Flüssigkeit mit solch einem Material oder einer solchen Materialmischung auf ein oder mehreren Stützelementen (z.B. einer hitzebeständigen Platte) in einer dünnen Schicht platziert wird, dann geschmolzen (z.B. durch selektives Laserschmelzen) oder gesintert (z.B. durch LaserSintern) wird, um eine teilweise oder ganz gehärtete Schicht zu erhalten, deren gehärteter Teil in seiner Form im Wesentlichen oder vorzugsweise vollständig einem Querschnitt des Endproduktes entspricht, wobei bei teilweiser Härtung (Selektives Lasersintern

= SLS (Selective Laser Sintering) ein nicht gehärteter Materialüberschuss (der beispielsweise Hohlräumen oder Öffnungen des Endproduktes entspricht) entfernt werden kann, jeweils nach Schmelzen oder Sintern einer Schicht oder zu einem späteren Zeitpunkt (dann dient das nicht geschmolzene Material beispielsweise als Unterlage beim Auftragen von neuem pulverförmigem oder anderweitig feinkörnigem oder Flüssigkeiten mit solchen Materialien, gefolgt von Auftragen einer neuen Schicht und deren teilweises oder vollständiges Schmelzen oder Sintern und ggf. Entfernen von überschüssigem nicht verschmolzenem Material, wie jeweils vorstehend beschrieben, und Wiederholung dieser Prozesse bis zur Fertigstellung einer vollständigen Mikrowellenbrücke.

Alternativ kann statt der schichtweisen Behandlung ein 3D-Druckverfahren angewendet werden, bei dem das Material punktweise aufgebracht und verschmolzen/gesintert wird bis zur Fertigstellung der vollständigen Mikrowellenbrücke. Beispielsweise können folgende Verfahren gewählt werden: Binder Jetting, Directed Energy Deposition, Material Extrusion (insbesondere nach dem FDM-Verfahren der stratasys), Material Jetting (das auch eine laterale Schichtapplikation erlaubt und so eine bevorzugte Variante darstellen kann, Hybridmethoden (z.B. Thermal Metal Spray, 5-Achsen-CNC, intermediate melting, "Alloys on the Fly"), Powder Bed Fusion (Laser Melting oder Electron Beam Melting), Sheet Lamination, VAT Photopolymerisation, oder (als flüssige Variante) Continuous Liquid Interface Production, oder High Speed Sintering.

Auch chemische oder rein physikalische Verfahren kommen in Frage, insbesondere im Rahmen von 3D-Druck. Hierbei können punkt- oder schichtweise beispielsweise durch UV-Licht härtbare Kunstharze (insbesondere solche, die radikalisch polymerisierbar sind, wie Vinylgruppen tragende Oligomere oder Präpolymere), durch Wärme härtbare Kunstharze (z.B. Epoxidharze mit Polyaminen als Härter oder Isocyanate mit Polyaminen als Härter), denen jeweils Metalle als Pulver oder in anderer feinteiliger Form beigemischt sind, oder Kunststoff/Metallteilchen-Dispersionen, die durch Trocknen aushärten können (physikalische Bindung der Partikel).

Erforderlichenfalls kann eine Nachbearbeitung der so erhaltenen Mikrowellenbrücke erfolgen, beispielsweise durch subtraktive Bearbeitung, wie Schleifen oder Fräsen (z.B. mittels 5-Achsen-CAD/CAM-Geräten) oder andere spanabhebende Verfahren oder Polieren oder Kombination von zwei oder mehr derartigen Verfahren.

Einheit bedeutet insbesondere, dass die Mikrowellenbrücke ohne Verbindung von Teilen durch "makroskopische" Füge- und Verbindungsverfahren wie Kleben, Schweißen, Formschluss wie Einrasten oder Kraftschluss wie Klemmen hergestellt ist und somit nicht aus Teilen zusammengesetzt ist, aber sehr wohl aus unterschiedlichen Komponenten und Materialbereichen (z.B. bei der Mikrowellenreflektionsstrecke in Form eines Koaxialkabels innen leitendes Metall, außen Isolatormaterial) bestehen kann. Dabei kann es durchaus zu Wechseln in der Zusammensetzung unterschiedlicher Abschnitte kommen. Die Abschnitte Resonator, Oszillator und Mikrowellenreflektionsstrecke bilden ein zusammenhängendes, nicht ein aus makroskopischen Teilen (wie einem Resonator, einer Mikrowellenreflektionsstrecke und einem Oszillator durch Zusammensetzen hergestelltes Teil aus.

Das Verfahren erfolgt vorzugsweise unter Kontrolle und Führung durch CAD/CAM-Daten, insbesondere unter geeigneter Datenprozessierung, um Toleranzkompensation nach dem additiven Herstellungsprozess und gute Oberflächenqualität und bei einer Nachbearbeitung hinreichenden Materialüberschuss zum Abtragen zu ermöglichen.

Materialien für die Verfahren sind Metalle wie Gold oder Silber, Legierungen (insbesondere CuZn37), metallhaltige Kunststoffe und Beschichtungsmaterialien, wie aus den Beispielen und sonstigen Abschnitten der Beschreibung ersichtlich.

Vorzugsweise liegt die maximale relative Permeabilität des Resonanzköper-Abschnittes bei 1,0001 oder niedriger (nachgewiesen mit Förstersonde. Vorzugsweise liegen die Toleranzen der Bearbeitung der Mikrowellenbrücke (insbesondere im Resonanzkörper) bei Toleranzklasse IT6, geschliffen, die Rauigkeit der Oberfläche entspricht höchstens Rz 6 (gemittelte Rautiefe in $\mu$m), Ra 0,3 (Mittenrauwert in $\mu$m) ohne sichtbare Beschädigungen. Sichtprüfung erfolgt bei 1000 mm Abstand von der Lampe unter einer Prüflampe mit 1500 Lux, Sichtabstand 800 mm. Eine Innenbeschichtung mit Gold 10 $\mu$m, Hartgold 10 $\mu$m unmagnetisch oder Helodor 635 (eine Goldlegierung) ist möglich und kann im Rahmen des 3D- oder anderen Herstellungsverfahrens wie oben beschrieben oder anschließend durch Aufdampfen aufgebracht werden.

Auch der Probenhalter, der im Anwendungsfall innerhalb des Probenraums (Resonator = Resonanzkörper) eingesetzt ist, kann vorzugsweise durch eines der für die Mikrowellenbrücke genannten Verfahren, insbesondere 3D-Druck, hergestellt werden.

Geeignete Materialien für die Probenaufnahme sind Kunststoffe wie PTFE oder synthetisches Quarzglas. Verunreinigungen mit Metallen wie $Fe2+$, $Cu2+$ ergeben ein Hintergrundsignal und sind daher möglichst zu vermeiden.

Vorzugsweise kann auch das Gehäuse einer erfindungsgemäßen Vorrichtung, oder Teile des Gehäuses, einschließlich von Elementen zur Abschirmung der Mikrowellenstrahlung nach außen, analog einem der für die Herstellung der Mikrowellenbrücke genannten Verfahren hergestellt werden bzw. danach hergestellt sein.

Auch die genannten Herstellungsverfahren sind mögliche beanspruchbare Erfindungsgegenstände.

Die Ansprüche definieren erfindungsgemäße Ausführungsformen der Erfindung, weshalb sie hier durch Bezugnahme inkorporiert werden.

Abbildungen (Figuren):

Fig. 1 zeigt in schematischer Aufsicht exemplarisch eine erfindungsgemäße Vorrichtung.

Fig. 2 zeigt schematisch den Aufbau einer Mikrowellenbrücke eines ESR-Spektrometers einer erfindungsgemäßen Vorrichtung. Außerdem werden ein Empfänger, ein Modulationsgenerator und Magnetspulen schematisch dargestellt.

Fig. 3 zeigt als Blockschema eine erfindungsgemäße Vorrichtung in Form eines ESR-Spektrometers.

Fig. 4: Graphische Darstellung der 1. Ableitung der EPR-Signale für Spinprobe und Tritylverbindung zur Messung der O2-Radikale und Sauerstoffkonzentration

Fig. 5 zeigt die Differenz der ROS-Generierung zwischen der Messung mit und ohne Inhibierung im Rahmen einer Blutprobe.

Die nachfolgenden Beispiele dienen als besondere Ausführungsform der Illustration der Erfindung, ohne ihren Umfang einzuschränken.

Beispiel 1:

Eine erfindungsgemäße Vorrichtung zur Messung von Vitalparametern **1** wird exemplarisch in Fig. 1 gezeigt.

In ihrem Inneren findet sich eine Mikrowellenbrücke **2** wie in Fig. 2 gezeigt. Diese umfasst den Resonator **2a,** den Oszillator **3** (als Mikrowellengenerator) und eine Mikrowellenreflektionsstrecke **4** und ist erfindungsgemäß in einem Stück mittels 3D-Druck hergestellt.

Der Oszillator 3 als Strahlungsquelle erzeugt im Anwendungsfall Mikrowellen im Bereich von 9-10 GHz (X-Band). Die Frequenz der Mikrowelle wird während einer Messung konstant gehalten und durch die Mikrowellenreflektionsstrecke **4.** als Hohlleiter oder im Beispiel als ein Koaxialkabel ausgeführt, in den Probenraum **5,** der den Probenhalter (nicht gezeigt) enthält, mit einer Magnetspaltbreite zwischen den einander zugewandten Flächen der Magneten **6** von 10 bis 14 mm, z.B. 12mm, geleitet. Der Probenraum **5** beinhaltet einen Hohlraum-Resonator (Resonator **2a**) (mit dem eigentlichen Raum für die Probe) in hier rechteckiger (oder alternativ zylindrischer) Form und bildet die sogenannte Cavity. Er befindet sich zwischen den zwei Magnetpolen 6 von Permanentmagneten von 2 kg Gewicht mit 60 mm Poldurchmesser mit im Beispiel 0,3476 T (3476 G) Feldstärke an dem zwei Magnetspulen 6a zur Modulation des Felds anliegen (statt der Permanentmagneten wären auch Elektromagneten denkbar). Durch geeignete Ankopplung (Tuning) wird beim Messvorgang eine stehende Welle ausgebildet. Da die Änderung der Amplitude einer derartigen Welle bei nur einem linearen Durchlauf (Scan) des magnetischen Feldes zu klein wäre, um ein geeignetes Signal-Rausch-Verhältnis zu erzielen, wird das magnetische Feld während des Messvorgangs von niederem zu höherem Feld (Scan) zusätzlich beispielsweise mit 100 kHz moduliert. Die Amplitude der Schwingung (der Magnetfeldstärke je Scan lässt sich im Bereich von 0 bis 0,005 T (50 Gauss)) mittels eines Modulationsgenerators **7** variieren.

Ist für ungepaarte Elektronen die Resonanzbedingung erfüllt, so absorbiert das System Mikrowellenstrahlung, was mittels eines Empfängers **8** gemessen werden kann.

Die biologische Probe wird bei einer Messung erfindungsgemäß mittels einer Kapillare **9** im diese umgebenden Probenhalter (nicht hervorgehoben), die erfindungsgemäß aus gaspermeablem (insbesondere für Sauerstoff) Kunststoff, hier Teflon, ausgeführt ist, dem Probenraum **5** mit dem darin vorliegenden Probenhalter (nicht gezeigt) zugeführt oder (beispielsweise mittels einer peristaltischen Pumpe) durch diesen geleitet. Sie kann im Durchfluss (z.B. 10 $\mu$L/Sek) oder ohne Fluss gemessen werden. Die Kapillare **9** weist ein Mess- und Probenvolumen im Bereich des Probenraums **5** und des darin gegebenen Messbereiches von 30 $\mu$l, im Beispiel vom 10-12 $\mu$L auf. Die Kapillare **9,** ausgebildet beispielsweise als Einwegkapillare, hat einen äußeren Durchmesser von z.B. 1,20 mm,

Der (nicht gezeigte) Probenhalter, hier als Quarzröhrchen mit innenliegender Kapillare **9,** ist in Anwendung im Probenhalter des Resonators **2a** derart eingesetzt, dass er im Bereich des maximalen magnetischen Feldes der stehenden Welle zu liegen kommt. Die Temperierung der Probe erfolgt durch Thermostabilisierung an der äußeren Oberfläche des Probenhalters mittels Durchpumpen von auf 36.6 +/- 0,1 °C aufgeheizter Luft. Dabei erfolgt die Thermostabilisierung der Probe bereits nach 20-30 Sekunden, bedingt durch ca. 3-fachen Materialvolumenunterschied. Das Einleiten von Gasgemisch mit entsprechender $O_2$ (4.0%), N $(95.5\%)_2$ und $CO_2$ (0.5%) Konzentration in den Kapillarhalter mit einer Flußrate von 0.6 mL/min ermöglicht das Erreichen der physiologischer pO2 Konzentration von 5332,88 +/- 133,322 Pa (40 +/- 1 mmHg) der biologischen Probe, welche sich in der gaspermeablen Kapillare befindet, innerhalb

von 20-30 Sekunden.

Fig. 3 zeigt ein Blockschema wesentlicher Teile einer erfindungsgemäßen Vorrichtung zur Messung metabolischer Aktivität /respiratorischer Intensität "Vitality Test" - gemessen anhand der Bildung von ROS.

Die Mikrowellenbrücke **2** leitet die erzeugten elektromagnetischen Schwingungen während einer Messung zum Probenraum **5** mit dem Resonator **2a** zwischen den Magnetpolen **6a.** Eine Magnetfeldkontrolleinheit **11** kontrolliert das durch die Magnetspulen **6a** auf das Feld der Permanentmagneten **6** aufgelagerte Magnetfeld, unterstützt von einem Hall-Sensor (nicht gezeigt), welcher das Magnetfeld misst. Mittels einer Einheit zur Gaskontrolle **12** wird der Sauerstoffpartialdruck über die Gasleitung **13** eingestellt und kontrolliert, mittels einer Temperaturkontrolleinheit **14** wird die Temperatur durch Zufuhr von temperierter Luft über die Luftleitung **15** eingestellt und kontrolliert.

Eine biologische Probe (z.B. menschliches Vollblut) wird mittels einer Pipette in die (hier gaspermeable) Kapillare **9** (beide in Fig. 3 nicht gezeigt) zugeführt. Die biologische Probe wird in einem geeigneten Puffer, der eine Spinprobe-Substanz aus der Klasse zyklisches Hydroxylamine (z.B. 1-Hydroxy-4-phosphono-oxy-2,2,6,6-tetramethylpiperidin = PPH oder 1-Hydroxy-3-methoxycarbonyl-2,2,5,5-tetramethylpyrrolidin = CMH; beide Noxygen GmbH, Elzach, Deutschland) in der Endkonzentration von 200μM) beinhaltet; vermischt und in dem Probenraum **5** im darin enthaltenen Probenhalter (nicht gezeigt) platziert. Zur Simultananalyse der Sauerstoffkonzentration bzw. des Sauerstoffverbrauches neben der ROS-Bildung kann ein sauerstoffsensitives (Spin-)Label (NOX.15.1 (gleich Tris(8-Carboxyl-2,2,6,6-tetramethylbenzo-[1,2-d;4,5-*d'*]bis[1,3]dithiol-4-yl)methyl-Natriumsalz, allgemein als "Trityl-Radical" bekannt; Noxygen GmbH, Elzach, Deutschland) zugesetzt sein Alternativ und vorzugsweise ist mindestens die Spinprobe oder das sauerstoffsensitive (Spin-)Label oder beides an die Kapillarwand gebunden.

Die Probenaufbereitung für eine Messung geschieht wie folgt: Krebs-HEPES-Puffer (KHB) wird hergestellt. Dazu wird das KHB-Pulver (Endkonzentration 20mM) in 0.5 l EPR-Wasser (Noxygen) aufgelöst. Der pH-Wert wird auf 7,4 eingestellt vor jeder Verwendung, so dass sich das Pulver auflöst (36% HCl, ungefähr 600 μl je 0.5 l KHB). Der Puffer wird gefiltert unter Verwendung eines 0.22 μm Filters und kann im Eisschrank bei +4 °C für bis zu 4 Wochen aliquotweise gelagert werden.

Stammlösungen von CMH in KHB (pH 7,4) mit 25 μM Deferoxamin und 5 μM Diethylthiocarbamat (DETC) (beide binden Metallionen und verhindern so eine Fenton-Reaktion) werden hergestellt. Pro 100 ml Deferroxamin/DETX-KHB werden gelöst:

1. DETC (MG = 225,31 g/mol): $5\mu M = 5 \times 10^{-6} \frac{mol}{l} \times 225{,}31 \frac{g}{mol} = 0{,}00112 \frac{g}{l} = 0{,}112 \frac{mg}{100ml}$

   1,12 mg DETC werden in 100 ml KHB gelöst.
   10 ml dieser Lösung werden entnommen und 90 ml KHB zugesetzt.

2. Deferoxamine (MG = 656,79 g/mol): $25\ \mu M = 25 \times 10^{-6} \frac{mol}{l} \times 656{,}79 \frac{g}{mol} = 0{,}0164 \frac{g}{l} = 1{,}64 \frac{mg}{100ml}$

   1,64 mg Deferoxamin warden zu der DETC/KHB-Lösung hinzugefügt.

Die zu verwendenden Pipettenspitzen werden mit Heparin vor Verwendung beschichtet. 20 μl Kapillarblut werden mit der heparinisierten Pipette aufgenommen. Mit einem Probenschüttler wird kurz (2 bis 3 Sekunden) in einem Eppendorf-Cup vermischt.

Dann wird mittels des ESR-Spektrometers wie beschrieben die Produktion von ROS und O2 gemessen.

Für die ESR-Detektion werden folgende Einstellungen des ESR-Spektrometers gewählt: Zentrales Feld 2.0 g, Mikrowellenenergie 20 mW, Modulationsamplitude 2.0 G, Durchgangs (Sweep)-Zeit 5,4 Sekunden (10 Scans), Feld-Sweep 60 G.

Alternativ kann die Spinprobe-Substanz kovalent an die Innenseite der Kapillare 9 gebunden sein.

Eine Signalkanaleinheit **16** nimmt das Messsignal aus einem Empfänger **8** (siehe Fig. 2) auf und wandelt es (darstellbar über ein Display oder einen Plotter, beide nicht gezeigt) in ein Spektrum **17** um, auf dessen x-Achse die Magnetfeldstärke $B_0$ und auf dessen y-Achse die Absorptionsintensität (hier als erste Ableitung) dargestellt sind. Die entsprechende graphische Darstellung des Spektrums ist in Fig. 4 noch einmal vergrößert dargestellt. Dort sind die ROS-Signale (drei Pfeile ausgehend vom linken Spinprobe-Molekül dargestellt) und das Signal für den Sauerstoffgehalt (Pfeil, der von der rechts dargestellten Tritylverbindung ausgeht) erkennbar gemacht. Die durchgezogene Linie entspricht dem für die Messung der ROS erhaltenen Signal (Spinprobe), die gestrichelte Linie dem Signal für Sauerstoff (auf Basis des Tritylradikals). Die erhaltenen Informationen über die so ermittelten Peaks (insbesondere die Signalintensität) erlauben allgemein eine relative (oder bei Verwendung von Eichkurven auch quantitative) Bestimmung der ROS und O2 der biologischen Proben

Beispielsweise werden in einer Variante des Beispiels die Messsignale mittels eines programmierten Computers (ggf. mittels einer oder mehrerer Eichkurven) automatisch in Informationen über Konzentrationen von Radikalen umgewandelt.

Die Einheit zur Gaskontrolle **12** und die Temperaturkontrolleinheit **14** dienen zur Einstellung der Temperatur und des Sauerstoffpartialdruckes, die auch entsprechende Sensoren beinhalten (nicht gezeigt), sind erfindungsgemäß in die erfindungsgemäße Vorrichtung integriert und halten die Temperatur im Probenhalter und damit in der Kapillare **9** während eines Messvorgangs im Bereich von 36,6 °C +/- 0,1 °C und den Sauerstoffpartialdruck im Bereich von 5332,88 +/- 266,644 Pa (40 mmHg +/- 2 mmHg). Somit sind physiologische Bedingungen wie in einem Kapillargefäß des Körpers des Probanden während der Messung gegeben.

Die vorstehende Beschreibung des Beispiels mischt Verwendungs- (Verfahrens-) und Vorrichtungselemente, doch ist bei Verwendung von verwendungs-/verfahrensausgerichteten Merkmalen stets davon auszugehen, dass hinsichtlich der Vorrichtung gemeint ist, dass die Vorrichtung entsprechend eingerichtet ist bzw. die genannten Komponenten aufweist.

<u>Beispiel 2: Differentielle Messung mit und ohne Effektor.</u>

Bei Verwendung der Spinprobe CMH, welches die Gesamtbildung von reaktiven Sauerstoffspezien (Intra- und Extrazelullär) darstellt, werden für die Radikale Werte zwischen 240 nM/sek und 300 nM/sek erzielt. Diese Art der Analyse nennen wir "Vitality" Test. Wiederholte Messung eines anderen Teils der Blutprobe mit vorheriger Zugabe von Antimycin A (10$\mu$M Endkonzentration), welches die Blockade des Komplexes III somit Elektronen Transfer innerhalb der mitochondrialen Atmungskette hervorruft und somit die mitochondriale Bildung von reaktiven Sauerstoffspezies blockiert, hat eine 10- bis zu 20%-ige Reduktion der ROS Bildung zur Folge. (ESR-Einstellungen wie in Beispiel 1).

Fig. 5 zeigt schematisch und exemplarisch eine Differenz der ROS-Generierung zwischen der Messung mit (gestrichelte Linie) und ohne Inhibierung (drei Pfeile, durchgezogene Linie) im Rahmen der Messung einer Blutprobe ("Extended Vitality Test") wie gerade beschrieben.

## Patentansprüche

1. Verwendung einer ESR-Vorrichtung zur differentiellen Charakterisierung von mindestens zwei unterschiedlichen Zuständen einer biologischen Probe, wobei

   - in einem ersten Schritt mittels ESR und eines Spinprobes in Form eines ungeladenen oder eines negative Gruppen tragenden zyklischen Hydroxylamins reaktive Sauerstoffspezies (ROS), reaktive Stickstoffspezies (RNS) oder beides und/oder mittels Verbindungen, die durch Anlagerung von Sauerstoff je nach Sauerstoffpartialdruck unterschiedliche Breite des oder der ESR-Absorptions-Peaks mit Verbreiterung bei zunehmender Sauerstoffkonzentration zeigen ohne chemische Reaktion, also durch rein physikalische Wechselwirkungen, die durch die Nähe unterschiedlicher Mengen an Sauerstoff entstehen, die Sauerstoffkonzentration der biologischen Probe ohne Zusatz von Effektoren gemessen werden und
   - in einem zweiten Schritt mittels ESR mittels eines Spinprobes in Form eines ungeladenen oder eines negative Gruppen tragenden zyklischen Hydroxylamins die ROS, die RNS oder die ROS und die RNS einer gleichen biologischen Probe jeweils unter Zusatz von Effektoren gemessen werden,
   wobei die Reihenfolge von erstem und zweitem Schritt auch beliebig sein kann;
   und/oder
   - aufgrund von mindestens zwei ESR-Messungen der biologischen Probe mit unterschiedlichen Spinprobes, die in unterschiedlicher Weise extrazelluläre Flüssigkeit, intrazelluläre Flüssigkeit und das Innere von Mitochondrien erreichen können, mit oder ohne Bestimmung der Sauerstoffkonzentration mittels Verbindungen, die durch Anlagerung von Sauerstoff je nach Sauerstoffpartialdruck Verbreiterung eines Peaks der ESR-Absorption bei zunehmender Sauerstoffkonzentration zeigen ohne chemische Reaktion, also durch rein physikalische Wechselwirkungen, die durch die Nähe unterschiedlicher Mengen an Sauerstoff entstehen, unterschiedliche Messergebnisse erhalten werden;
   und jeweils durch Vergleich der unterschiedlichen Messergebnisse unter Differenzbildung aus der Differenz Schlüsse auf die Vitalität oder die Gesundheit eines Patienten oder gesunden Probanden, von dem die biologische Probe stammt, gezogen werden;
   wobei die Messung bei einer Temperatur in der biologischen Probe in einem Bereich von 36 bis 44 °C und der Sauerstoffpartialdruck in einem Bereich von 2666,44 - 7332,71 Pa eingestellt ist;
   und
   wobei unter "Effektoren", wo erwähnt, Inhibitoren oder Aktivatoren oder sonstige Modulatoren, von Enzymen, Enzymsystemen oder Organellen zu verstehen sind, die auf die Bildung von ROS und/oder RNS Einfluss haben.

2. Verwendung nach Anspruch 1, wobei die Messung mittels einer tragbaren Vorrichtung gemäß Anspruch 4 durchgeführt wird.

3. Verwendung nach einem der Ansprüche 1 oder 2, **dadurch gekennzeichnet, dass** eine tragbare Vorrichtung gemäß Anspruch 5 verwendet wird.

4. Tragbare Vorrichtung (1) zur Messung von Vitalparametern, welche ein ESR-Gerät mit einem Resonator (2a) mit einem eingesetzten Probenhalter mit einer Kapillare (9) zur Aufnahme einer biologischen Probe beinhaltet, **dadurch gekennzeichnet, dass** die Kapillare (9) im Probenhalter gasdurchlässig ist mindestens für Sauerstoff, und Kontrollelemente für Temperatur und Sauerstoffpartialdruck und Elemente zur Einstellung der Temperatur und des Sauerstoffpartialdruckes in die Vorrichtung integriert sind, die dafür eingerichtet sind, im Messbereich die Temperatur in der biologischen Probe in einem Bereich von 36,6 +/-0,5 °C und den Sauerstoffpartialdruck in einem Bereich von 4666,27-6666,10 Pa einzustellen.

5. Tragbare Vorrichtung (1) nach Anspruch 4, **dadurch gekennzeichnet, dass** das ESR-Gerät eine Mikrowellenbrücke (2), welche den eingesetzten Probenhalter, den Resonator (2a), einen Oszillator (3) und eine Mikrowellenreflektionsstrecke (4), die als Koaxialkabel ausgebildet sein kann, umfasst, als eine Einheit durch, jeweils schichtweises und/oder punktweises, Aufschmelzen und/oder Sintern und/oder chemisches Umsetzen und im Falle der Verwendung von Kunststoff/Metallteilchen-Dispersionen unter Trocknen hergestellt, aufweist.

6. Vorrichtung nach einem der Ansprüche 4 oder 5, **dadurch gekennzeichnet, dass** sie 4 oder mehr der folgenden Merkmale aufweist:

   - Messbereich von 100 bis 500 nMol/sek, insbesondere von 150 bis 360 nMol/sek, vorzugsweise von 240 bis 300 nMol/sek;
   - Genauigkeit, also Signal/Rauschverhältnis vorzugsweise von 5 % oder besser;
   - Auflösung gleich oder mehr als 3 x $10^{-4}$ T;
   - Feldstabilität über 1 Stunde > 3 x $10^{-5}$ T;
   - Empfindlichkeit von < 5 nM/min;
   - Automatische Datensicherung, um die Daten zu sichern;
   - USB-Schnittstelle oder andere übliche Schnittstelle
   - Datenerfassungssoftware, die das Gerät steuert, die Messergebnisse erfasst und sie gewünschtenfalls auch auswerten kann;
   - Galvanische Trennung zwischen Datenschnittstelle und Stromversorgung.

7. Vorrichtung nach einem der Ansprüche 4 bis 6, **dadurch gekennzeichnet, dass** sie ein Gewicht im Bereich von 5 bis 20 kg, vorzugsweise von 7 bis 10 kg, hat und die Größe bei (200-500) x (100 bis 350) x (100 bis 350 mm) liegt.

8. Vorrichtung nach einem der Ansprüche 4 bis 7, **dadurch gekennzeichnet, dass** sie eine Leistungsaufnahme von weniger als 100 W, beispielsweise von 20 bis 50 W, hat.

9. Vorrichtung nach einem der Ansprüche 4 bis 8, **dadurch gekennzeichnet, dass** sie eine Magnetfeldbaugruppe beinhaltet, die mindestens 2 der folgenden Merkmale aufweist:

   - Permanentmagnet (6) mit 40 bis 70 mm Magnetpoldurchmesser;
   - Spulen (6a) zur Änderung der magnetischen Flussdichte im Bereich von +/- 0,1 G (+/-0,01 mT) bis +/- 0,5 G (+/- 0,05 mT);
   - Durchmesser des die Messzone definierenden Magnetfeldes 10 bis 30 mm;
   - Abstand zwischen den Magnetpolen (6, 6a) von 10 bis 30;
   - Abmessungsgenauigkeit reproduzierbar 10 $\mu$m, Rundheit 3 $\mu$m;
   - Magnetgewicht 1 bis 5 kg.

10. Vorrichtung nach einem der Ansprüche 4 bis 9 mit Magnetpolen (6, 6a), **dadurch gekennzeichnet, dass** der Resonator, gemessen in der Richtung zwischen deren Magnetpolen, 8 bis 10 mm groß ist, eine Öffnung für einen Probenhalter von 3 bis 5 mm Durchmesser aufweist, und die Kapillare (9) einen Durchmesser von 0,5 bis 2, insbesondere von 1,2 bis 1,5 mm hat.

11. Vorrichtung nach einem der Ansprüche 4 bis 10, **dadurch gekennzeichnet, dass** sie für eine Probenmenge im Messbereich bei 5 bis 30 $\mu$l, insbesondere 8 bis 15 $\mu$l, z.B. 10 $\mu$l, eingerichtet ist.

**12.** Vorrichtung nach einem der Ansprüche 4 bis 11, **dadurch gekennzeichnet, dass** sie eine mit mindestens einem Spinprobe zur Messung der ROS und/oder RNS und/oder mindestens einem sauerstoffsensitives Spinlabel zur Messung des Sauerstoffgehaltes auf der Innenseite beschichtete Kapillare (9) aufweist.

**13.** Vorrichtung nach einem der Ansprüche 4 bis 12, **dadurch gekennzeichnet, dass** ihr Probenhalter für die gleichzeitige Messung von zwei oder mehr identischen oder verschiedenen biologischen Proben eingerichtet ist durch entsprechende Anzahl von Probenräumen (5) oder Aufnahme von zwei oder mehr Kapillaren in einem einzigen Probenraum (5).

**14.** Verwendung gemäß Anspruch 2 einer tragbaren Vorrichtung wie in einem der Ansprüche 4 bis 13 definiert zur Bestimmung von reaktiven Sauerstoffspezies (ROS), Sauerstoff und/oder reaktiven Stickoxidspezies (RNS) in einer biologischen Probe, wobei mindestens ein zyklisches-Hydroxylamin als Spinprobe eingesetzt wird, die Messungen mittels ESR Absorptionsmessungen durchgeführt und die Messsignale gespeichert und/oder visualisiert und vorzugsweise automatisch ausgewertet werden.

## Claims

**1.** Use of an ESR device for the differential characterization of at least two different states of a biological sample, wherein

- in a first step, by means of ESR and a spin probe in the form of an uncharged or a cyclic hydroxylamine carrying negative groups, reactive oxygen species (ROS), reactive nitrogen species (RNS) or both and/or, by means of compounds, which, due to the addition of oxygen, show different widths of the ESR absorption peak(s) with broadening with increasing oxygen concentration depending on the oxygen partial pressure, without chemical reaction, i.e. by purely physical interactions which arise due to the proximity of different quantities of oxygen, the oxygen concentration of the biological sample is measured without the addition of effectors and
- in a second step, by means of ESR using a spin probe in the form of an uncharged or a cyclic hydroxylamine carrying negative groups, the ROS, the RNS or the ROS and the RNS of a same biological sample are measured in each case with the addition of effectors,

wherein the sequence of the first and second steps can also be arbitrary;
and/or

- different measurement results are obtained due to at least two ESR measurements of the biological sample with different spin probes, which can reach extracellular fluid, intracellular fluid and the interior of mitochondria in different ways, with or without determination of the oxygen concentration by means of compounds which show broadening of a peak of the ESR absorption with increasing oxygen concentration due to the addition of oxygen depending on the oxygen partial pressure without chemical reaction, i.e. due to purely physical interactions which arise due to the proximity of different amounts of oxygen;

and by comparing the different measurement results and calculating the difference, conclusions can be drawn about the vitality or health of a patient or healthy volunteer from whom the biological sample originates;
wherein the measurement is set at a temperature in the biological sample in a range of 36 to 44°C and the oxygen partial pressure is set in a range of 2666.44-7332.71 Pa;
and
wherein "effectors", where mentioned, are to be understood as inhibitors or activators or other modulators of enzymes, enzyme systems or organelles which have an influence on the formation of ROS and/or RNS.

**2.** Use according to claim 1, wherein the measurement is carried out by means of a portable device according to claim 4.

**3.** Use according to one of claims 1 or 2, **characterized in that** a portable device according to claim 5 is used.

**4.** Portable device (1) for measuring vital parameters, which includes an ESR device having a resonator (2a) with an inserted sample holder with a capillary (9) for receiving a biological sample, **characterized in that** the capillary (9) in the sample holder is gas-permeable at least for oxygen, and control elements for temperature and oxygen partial pressure and elements for setting the temperature and the oxygen partial pressure are integrated into the device, which are set up to set the temperature in the biological sample in a range of 36.6 +/-0.5°C and the oxygen partial pressure in a range of 4666.27-6666.10 Pa in the measuring range.

**5.** Portable device (1) according to claim 4, **characterized in that** the ESR device has a microwave bridge (2), which comprises the inserted sample holder, the resonator (2a), an oscillator (3) and a microwave reflection path (4), which can be designed as a coaxial cable, produced as a unit by melting and/or sintering and/or chemical conversion, in each case layer by layer and/or point by point, and in the case of the use of plastic/metal particle dispersions under drying.

**6.** Device according to one of claims 4 or 5, **characterized in that** it has 4 or more of the following features:

- Measuring range from 100 to 500 nMol/sec, in particular from 150 to 360 nMol/sec, preferably from 240 to 300 nMol/sec;
- Accuracy, i.e. signal/noise ratio preferably of 5% or better;
- Resolution equal to or more than 3 x $10^{-4}$ T;
- Field stability over 1 hour > 3 x $10^{-5}$ T;
- Sensitivity of < 5 nM/min;
- Automatic data backup to save the data;
- USB interface or other standard interface
- Data acquisition software that controls the device, records the measurement results and can also evaluate them if required;
- Galvanic isolation between data interface and power supply.

**7.** Device according to one of claims 4 to 6, **characterized in that** it has a weight in the range from 5 to 20 kg, preferably from 7 to 10 kg, and the size is (200 to 500) x (100 to 350) x (100 to 350 mm).

**8.** Device according to one of claims 4 to 7, **characterized in that** it has a power consumption of less than 100 W, for example from 20 to 50 W.

**9.** Device according to one of claims 4 to 8, **characterized in that** it comprises a magnetic field assembly having at least 2 of the following features:

- Permanent magnet (6) with 40 to 70 mm magnetic pole diameter;
- Coils (6a) for changing the magnetic flux density in the range from +/- 0.1 G (+/- 0.01 mT) to +/- 0.5 G (+/- 0.05 mT);
- Diameter of the magnetic field defining the measuring zone 10 to 30 mm;
- Distance between the magnetic poles (6, 6a) from 10 to 30;
- Reproducible dimensional accuracy 10 μm, roundness 3 μm;
- Magnet weight 1 to 5 kg.

**10.** Device according to one of claims 4 to 9 with magnetic poles (6, 6a), **characterized in that** the resonator, measured in the direction between their magnetic poles, is 8 to 10 mm in size, has an opening for a sample holder of 3 to 5 mm in diameter, and the capillary (9) has a diameter of 0.5 to 2, in particular of 1.2 to 1.5 mm.

**11.** Device according to one of claims 4 to 10, **characterized in that** it is set up for a sample quantity in the measuring range at 5 to 30 μl, in particular 8 to 15 μl, e.g. 10 μl.

**12.** Device according to one of claims 4 to 11, **characterized in that** it comprises a capillary (9) coated with at least one spin probe for measuring the ROS and/or RNS and/or at least one oxygen-sensitive spin label for measuring the oxygen content on the inside.

**13.** Device according to one of claims 4 to 12, **characterized in that** its sample holder is set up for the simultaneous measurement of two or more identical or different biological samples by means of a corresponding number of sample compartments (5) or accommodation of two or more capillaries in a single sample compartment (5).

**14.** Use according to claim 2 of a portable device as defined in one of claims 4 to 13 for the determination of reactive oxygen species (ROS), oxygen and/or reactive nitrogen oxide species (RNS) in a biological sample, wherein at least one cyclic hydroxylamine is used as spin probe, the measurements are carried out by means of ESR absorption measurements and the measurement signals are stored and/or visualized and preferably evaluated automatically.

## Revendications

1. Utilisation d'un dispositif de RPE (résonance paramagnétique électronique) pour la caractérisation différentielle d'au moins deux états différents d'un échantillon biologique, dans laquelle

   - dans une première étape, au moyen de la RPE et d'un échantillon de spin sous la forme d'une hydroxylamine cyclique non chargée ou portant des groupes négatifs, des espèces réactives de l'oxygène (ROS), des espèces réactives de l'azote (RNS) ou les deux et/ou au moyen de composés qui, par fixation d'oxygène, en fonction de la pression partielle d'oxygène, présentent une largeur différente du ou des pics d'absorption RPE, avec un élargissement lorsque la concentration en oxygène augmente, sans réaction chimique, c'est-à-dire par des interactions purement physiques qui résultent de la proximité de quantités différentes d'oxygène, la concentration en oxygène de l'échantillon biologique est mesurée sans addition d'effecteurs et
   - dans une deuxième étape, les ROS, les RNS ou les ROS et les RNS d'un même échantillon biologique sont mesurées par RPE à l'aide d'un échantillon de spin sous la forme d'une hydroxylamine cyclique non chargée ou portant des groupes négatifs, dans chaque cas avec addition d'effecteurs,

   l'ordre de la première et de la deuxième étape pouvant également être quelconque ;
   et/ou
   sur la base d'au moins deux mesures par RPE de l'échantillon biologique avec des sondes de spin différentes, qui peuvent atteindre de manière différente le liquide extracellulaire, le liquide intracellulaire et l'intérieur des mitochondries, avec ou sans détermination de la concentration en oxygène au moyen de composés qui, par fixation d'oxygène, en fonction de la pression partielle d'oxygène, présentent un élargissement d'un pic de l'absorption RPE lorsque la concentration en oxygène augmente, sans réaction chimique, c'est-à-dire par des interactions purement physiques qui résultent de la proximité de quantités différentes d'oxygène, on obtient des résultats de mesure différents ;
   et, dans chaque cas, en comparant les différents résultats de mesure et en formant une différence à partir de la différence, on tire des conclusions sur la vitalité ou la santé d'un patient ou d'un sujet sain dont provient l'échantillon biologique ;
   la mesure étant effectuée à une température de l'échantillon biologique dans une plage de 36 à 44 °C et la pression partielle d'oxygène étant réglée dans une plage de 2666,44 à 7332,71 Pa ;
   et
   dans laquelle on entend par "effecteurs", lorsqu'ils sont mentionnés, des inhibiteurs ou des activateurs ou d'autres modulateurs d'enzymes, de systèmes enzymatiques ou d'organelles, qui ont une influence sur la formation de ROS et/ou de RNS.

2. Utilisation selon la revendication 1, dans laquelle la mesure est effectuée au moyen d'un dispositif portable selon la revendication 4.

3. Utilisation selon l'une des revendications 1 ou 2, **caractérisée en ce que** l'on utilise un dispositif portable selon la revendication 5.

4. Dispositif portable (1) pour la mesure de paramètres vitaux, qui comprend un appareil de RPE avec un résonateur (2a) avec un porte-échantillon inséré doté d'un capillaire (9) pour recevoir un échantillon biologique, **caractérisé en ce que** le capillaire (9) dans le porte-échantillon est perméable aux gaz au moins pour l'oxygène, et des éléments de contrôle pour la température et la pression partielle d'oxygène ainsi que des éléments pour le réglage de la température et de la pression partielle d'oxygène sont intégrés dans le dispositif, qui sont conçus pour régler, dans la plage de mesure, la température dans l'échantillon biologique dans une plage de 36,6 +/-0,5 °C et la pression partielle d'oxygène dans une plage de 4666,27 à 6666,10 Pa.

5. Dispositif portable (1) selon la revendication 4, **caractérisé en ce que** l'appareil de RPE comprend un pont micro-ondes (2), qui comprend le porte-échantillon inséré, le résonateur (2a), un oscillateur (3) et un chemin de réflexion micro-ondes (4), qui peut être réalisé sous la forme d'un câble coaxial, et qui est fabriqué en tant qu'unité par fusion et/ou frittage et/ou réaction chimique, dans chaque cas par couches et/ou par points et, dans le cas de l'utilisation de dispersions de particules plastiques/métalliques, avec séchage.

6. Dispositif selon l'une des revendications 4 ou 5, **caractérisé en ce qu'**il présente 4 ou plus des caractéristiques suivantes :

- plage de mesure de 100 à 500 nmol/sec, en particulier de 150 à 360 nmol/sec, de préférence de 240 à 300 nmol/sec ;
- précision, c'est-à-dire rapport signal/bruit de préférence égal ou supérieur à 5 % ;
- résolution égale ou supérieure à $3 \times 10^{-4}$ T ;
- stabilité du champ sur 1 heure > $3 \times 10^{-5}$ T ;
- sensibilité < 5 nm/min ;
- sauvegarde automatique des données, afin de sauvegarder les données ;
- interface USB ou autre interface usuelle ;
- logiciel d'acquisition de données qui commande l'appareil, enregistre les résultats de mesure et, si souhaité, peut également les évaluer ;
- séparation galvanique entre l'interface de données et l'alimentation électrique.

**7.** Dispositif selon l'une des revendications 4 à 6, **caractérisé en ce qu'**il a un poids dans la plage de 5 à 20 kg, de préférence de 7 à 10 kg, et une taille de (200 à 500) x (100 à 350) x (100 à 350 mm).

**8.** Dispositif selon l'une des revendications 4 à 7, **caractérisé en ce qu'**il a une consommation électrique inférieure à 100 W, par exemple de 20 à 50 W.

**9.** Dispositif selon l'une des revendications 4 à 8, **caractérisé en ce qu'**il contient un ensemble magnétique présentant au moins 2 des caractéristiques suivantes :

- aimant permanent (6) de 40 à 70 mm de diamètre de pôle magnétique ;
- bobines (6a) pour faire varier la densité de flux magnétique dans la plage de +/- 0,1 G (+/- 0,01 mT) à +/- 0,5 G (+/- 0,05 mT) ;
- diamètre du champ magnétique définissant la zone de mesure de 10 à 30 mm ;
- distance entre les pôles magnétiques (6, 6a) de 10 à 30 ;
- précision dimensionnelle reproductible de 10 µm, circularité de 3 µm ;
- poids de l'aimant de 1 à 5 kg.

**10.** Dispositif selon l'une des revendications 4 à 9, comportant des pôles magnétiques (6, 6a), **caractérisé en ce que** le résonateur, mesuré dans la direction entre ses pôles magnétiques, a une taille de 8 à 10 mm, présente une ouverture pour un porte-échantillon de 3 à 5 mm de diamètre, et le capillaire (9) a un diamètre de 0,5 à 2, en particulier de 1,2 à 1,5 mm.

**11.** Dispositif selon l'une des revendications 4 à 10, **caractérisé en ce qu'**il est conçu pour une quantité d'échantillon dans la plage de mesure comprise entre 5 et 30 µl, en particulier entre 8 et 15 µl, par exemple 10 µl.

**12.** Dispositif selon l'une des revendications 4 à 11, **caractérisé en ce qu'**il présente un capillaire (9) revêtu sur sa face intérieure d'au moins une sonde de spin pour mesurer les ROS et/ou les RNS et/ou d'au moins une étiquette de spin sensible à l'oxygène pour mesurer la teneur en oxygène.

**13.** Dispositif selon l'une des revendications 4 à 12, **caractérisé en ce que** son porte-échantillon est conçu pour la mesure simultanée de deux ou plusieurs échantillons biologiques identiques ou différents par la présence d'un nombre correspondant de compartiments à échantillon (5) ou par la réception de deux ou plusieurs capillaires dans un seul compartiment à échantillon (5).

**14.** Utilisation selon la revendication 2 d'un dispositif portable tel que défini dans l'une des revendications 4 à 13 pour la détermination d'espèces réactives de l'oxygène (ROS), d'oxygène et/ou d'espèces réactives de l'oxyde d'azote (RNS) dans un échantillon biologique, dans laquelle au moins une hydroxylamine cyclique est utilisée comme échantillon de spin, les mesures sont effectuées au moyen de mesures d'absorption RPE et les signaux de mesure sont enregistrés et/ou visualisés et de préférence évalués automatiquement.

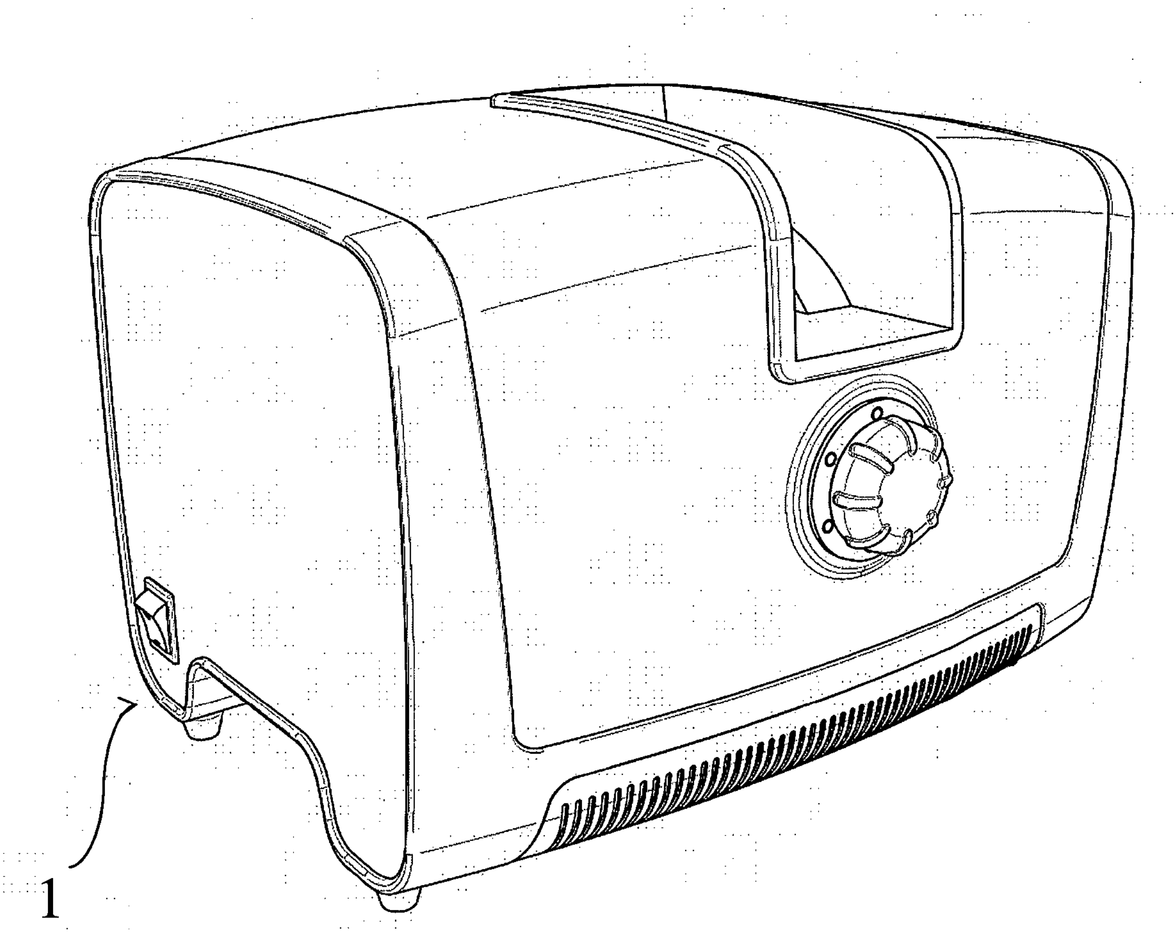


Fig. 1

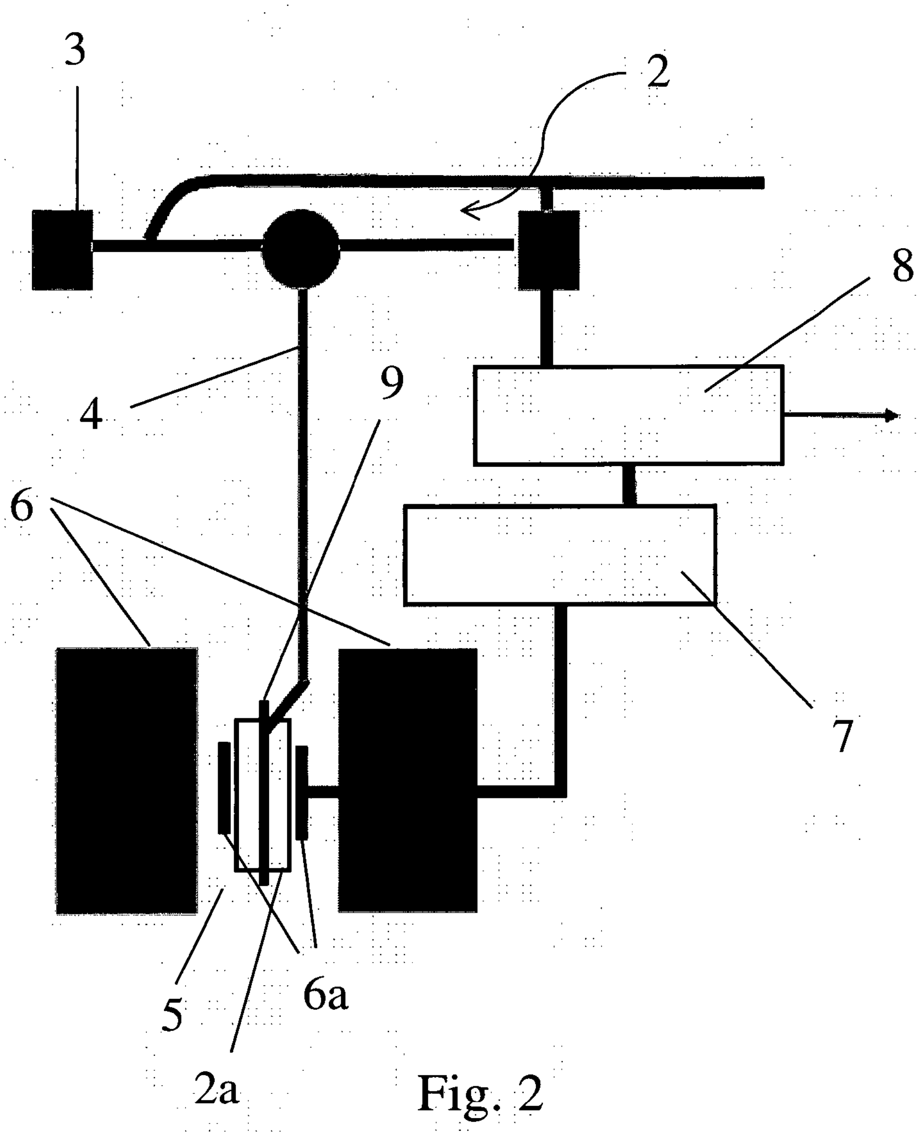


Fig. 2

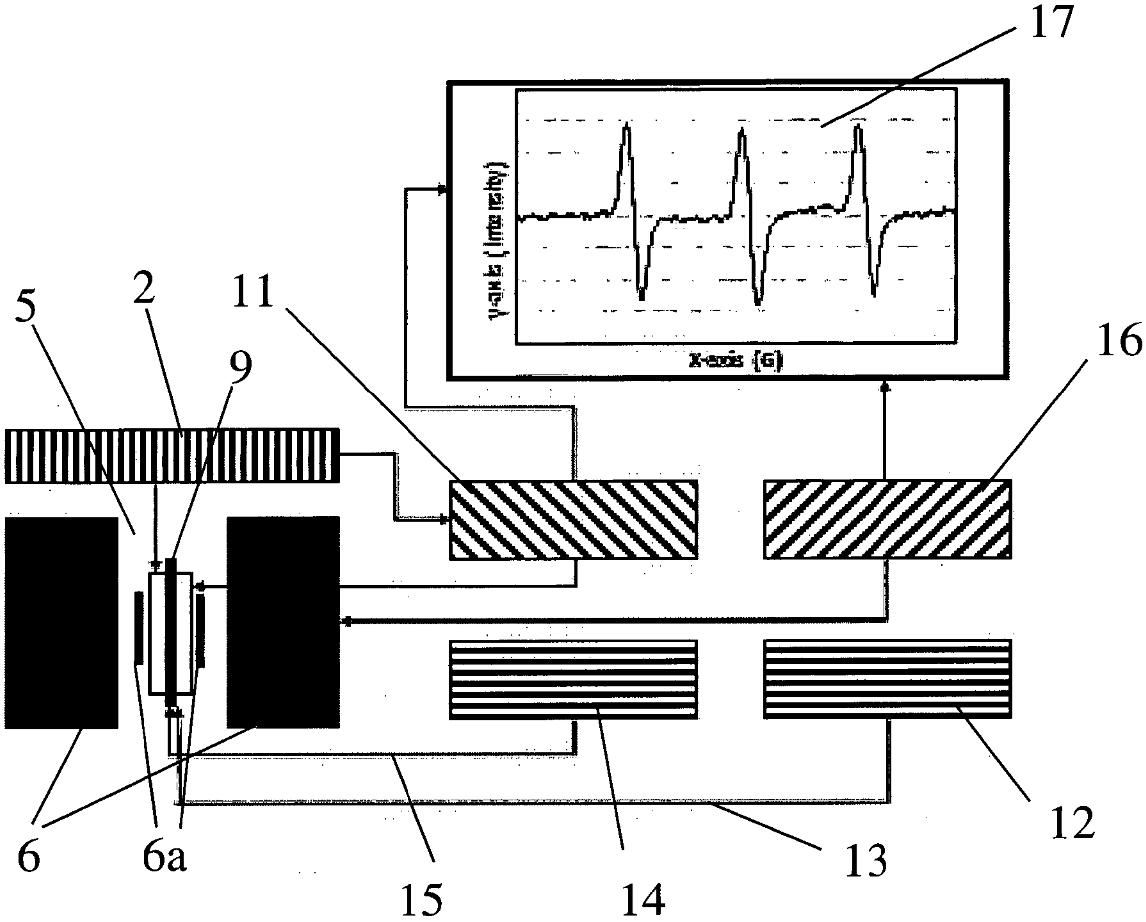


Fig. 3

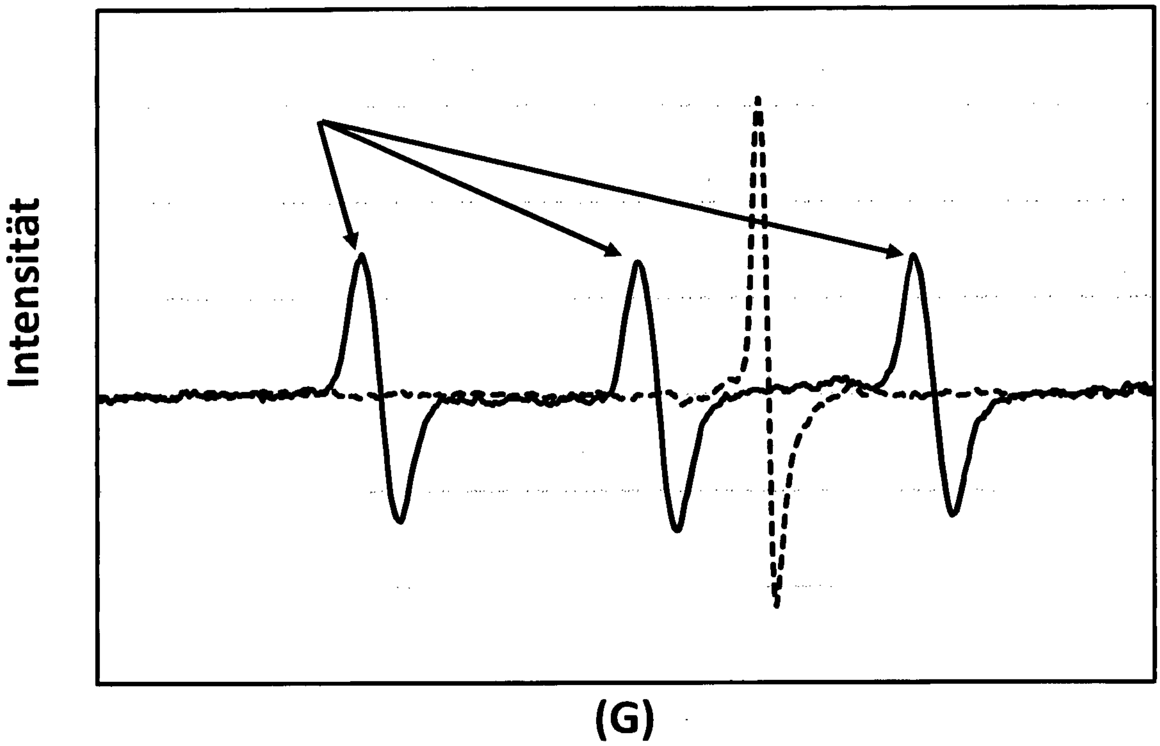


Fig. 4

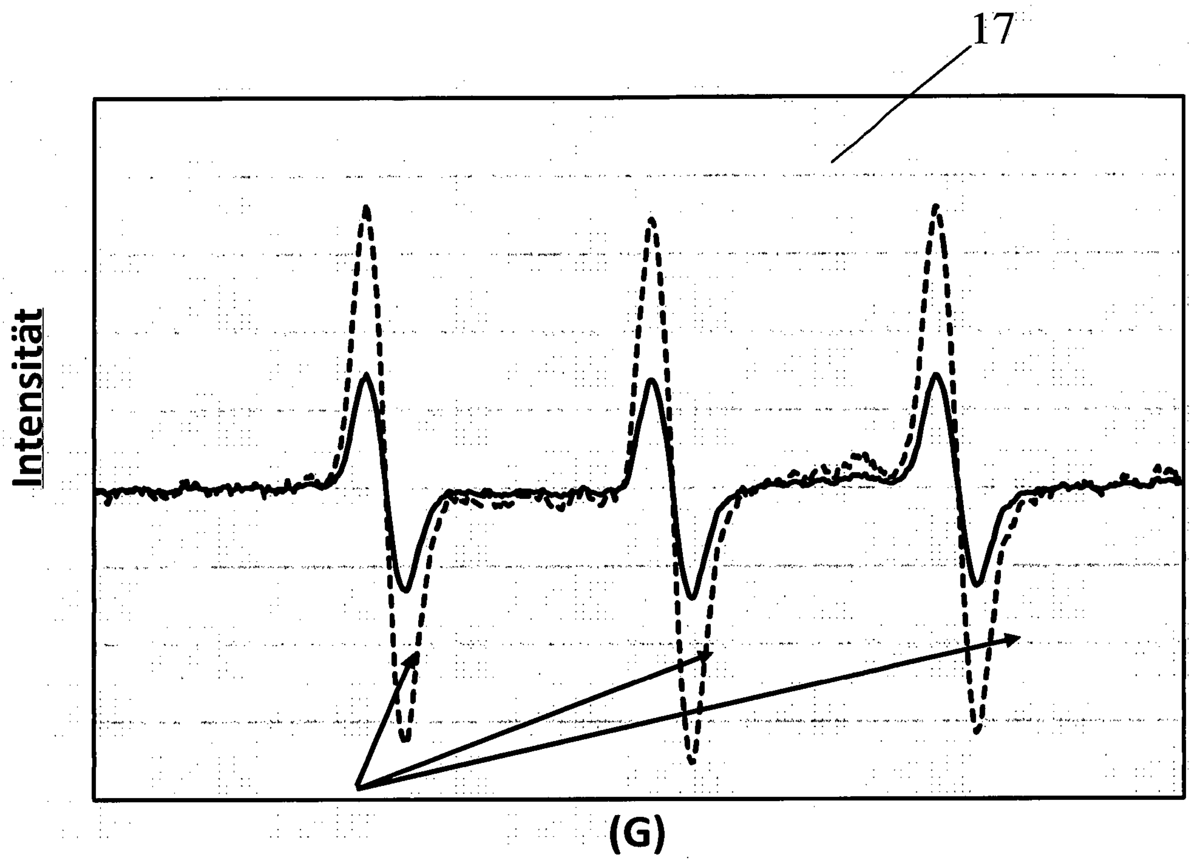


Fig. 5

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- WO 2012021453 A2
- US 2014091802 A1


### In der Beschreibung aufgeführte Nicht-Patentliteratur


- **NEMZER et al.** *Food Science & Nutrition,* 2014, 1-12
- **BOHNE et al.** *Inflammation Research,* 1997, vol. 46 (10), 423-424
- **ANGE MOUITHYS-MICKALAD et al.** *Redox Report,* 2002, vol. 7 (2), 85-94
- **EUN-RYEYONG HAHM et al.** *PLOS One, Bd,* 2011, vol. 6 (8), e23354
- **VON A. BOBKO et al.** 47. *Free Radical Biological Medicine,* 2009, 654-658
- **Y. LIU et al.** *Free Radic Biol Med.,* 01. April 2009, vol. 46 (7), 876-83